# EUROPEAN PATENT APPLICATION

(11) **EP 4 598 297 A1**
(43) Date of publication of application: **06.08.2025**
(21) Application number: 25154970.5
(22) Date of filing: 30.01.2025
(51) Int. Cl.: H10D 10/01, H10D 10/80, H10D 62/10, H10D 62/13, H10D 62/17, H10D 64/27

(54) **SEMICONDUCTOR DEVICE WITH MONOCRYSTALLINE EXTRINSIC BASE**

(30) Priority: 01.02.2024 US 202418430442
(71) Applicant: NXP B.V., 5656 AG Eindhoven (NL)
(72) Inventor: JOHN, Jay Paul, 5656AG Eindhoven (NL); KIRCHGESSNER, James Albert, 5656AG Eindhoven (NL); DONKERS, Johannes Josephus Theodorus Marinus, 5656AG Eindhoven (NL); WERKMAN, Ronald Willem Arnoud, 5656AG Eindhoven (NL); MAGNEE, Petrus Hubertus Cornelis, 5656AG Eindhoven (NL)
(74) Representative: Hardingham, Christopher Mark

(57) **Abstract**

A semiconductor device, such as a heterojunction bipolar transistor (HBT), having a monocrystalline extrinsic base region may be formed via a method including steps of providing a substrate that includes a dielectric isolation region and a collector region that includes semiconductor material, forming a polycrystalline semiconductor layer over the substrate, forming a monocrystalline intrinsic base layer via epitaxial growth, where the intrinsic base layer is in direct contact with the polycrystalline semiconductor layer, removing the polycrystalline semiconductor layer after forming the monocrystalline intrinsic base layer, and forming a monocrystalline extrinsic base layer via epitaxial growth, where the monocrystalline extrinsic base layer is in direct contact with the monocrystalline intrinsic base layer.

## Description

### TECHNICAL FIELD

Embodiments of the subject matter described herein relate generally to transistor devices, including bipolar junction transistors (BJTs) and heterojunction bipolar transistors (HBTs).

### BACKGROUND

Semiconductor devices find application in a wide variety of electronic components and systems. Moreover, useful semiconductor devices for radio frequency (RF), microwave, and millimeter wave applications may include bipolar junction transistors (BJTs), heterojunction bipolar transistors (HBTs), and related devices. In particular, HBTs are useful in high frequency applications because of their fast transit time, high cutoff frequency, high gain, and good linearity properties. These HBTs act as active gain elements and find applications as active devices in radio frequency (RF), microwave, and millimeter wave power amplifiers, oscillators, and other useful electronic components.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures. Elements in the figures are illustrated for simplicity and clarity and have not necessarily been drawn to scale. The figures along with the detailed description are incorporated and form part of the specification and serve to further illustrate examples, embodiments and the like, and explain various principles and advantages, in accordance with the present disclosure, wherein:
FIG. 1 is a cross-sectional side view of a transistor device, in accordance with various embodiments;
FIG. 2 is a process flow diagram describing a method for fabricating the transistor device of FIG. 1, in accordance with various embodiments;
FIGS. 3-11 are cross-sectional views depicting the transistor device of FIG. 1 at various stages of fabrication corresponding to, for example, blocks of the method of FIG. 2, in accordance with various embodiments;
FIG. 12 is a cross-sectional view of a transistor device in accordance with various embodiments;
FIG. 13 is a process flow diagram describing a method for fabricating the transistor device of FIG. 12, in accordance with various embodiments;
FIGS. 14-24 are cross-sectional views depicting the transistor device of FIG. 12 at various stages of fabrication corresponding to, for example, blocks of the method of FIG. 14, in accordance with various embodiments;
FIG. 25 is a cross-sectional view of a transistor device in accordance with various embodiments;
FIG. 26 is a process flow diagram describing a method for fabricating the transistor device of FIG. 25, in accordance with various embodiments;
FIGS. 27-39 are cross-sectional views depicting the transistor device of FIG. 25 at various stages of fabrication corresponding to, for example, blocks of the method of FIG. 26, in accordance with various embodiments; and
FIGS. 40-43 are cross-sectional views depicting alternative intermediate stages of fabrication of the transistor device of FIG. 25, in accordance with various embodiments.

### DETAILED DESCRIPTION

The following detailed description is merely illustrative in nature and is not intended to limit the embodiments of the subject matter or the application and uses of such embodiments. Furthermore, there is no intention to be bound by any expressed or implied theory presented in the preceding technical field, background, or the following detailed description.

For simplicity and clarity of illustration, the drawing figures illustrate the general manner of construction, and descriptions and details of well-known features and techniques may be omitted to avoid unnecessarily obscuring the present disclosure. Additionally, elements in the drawing figures are not necessarily drawn to scale. For example, the dimensions of some of the elements or regions in the figures may be exaggerated relative to other elements or regions to help improve understanding of embodiments described herein.

The terms "first," "second," "third," "fourth" and the like in the description and the claims, if any, may be used for distinguishing between similar elements and not necessarily for describing a particular sequential or chronological order. It is to be understood that the terms so used are interchangeable under appropriate circumstances such that the embodiments described herein are, for example, capable of operation in sequences other than those illustrated or otherwise described herein. Furthermore, the terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. The term "coupled," as used herein, is defined as directly or indirectly connected in an electrical or non-electrical manner. As used herein the terms "substantial" and "substantially" mean sufficient to accomplish the stated purpose in a practical manner and that minor imperfections, if any, are not significant for the stated purpose. As used herein, the words "exemplary" and "example" mean "serving as an example, instance, or illustration." Any implementation described herein as exemplary or an example is not necessarily to be construed as preferred or advantageous over other implementations. In addition, certain terms may also be used herein for reference only, and thus are not intended to be limiting. For the sake of brevity, conventional semiconductor fabrication techniques may not be described in detail herein.

Directional references such as "top," "bottom," "left," "right," "above," "below," and so forth, unless otherwise stated, are not intended to require any preferred orientation and are made with reference to the orientation of the corresponding figure or figures for purposes of illustration.

Various embodiments described herein provide a transistor, such as a heterojunction bipolar transistor (HBT) and an associated fabrication method in which an extrinsic base region and base link region of the HBT are formed from monocrystalline semiconductor material, such as monocrystalline silicon. HBT devices typically have a maximum oscillation frequency that is limited by two primary parasitic components: base resistance (i.e., the resistance between the base electrode of the HBT and the intrinsic base region) and collector-base junction capacitance (i.e., the capacitance between the base region of the HBT and the collector region of the HBT). The design and fabrication of HBT devices typically results in a trade-off between the base resistance and collector-base junction capacitance. For example, higher doped, deeper extrinsic base junctions in an HBT tend to result decrease base resistance but result in higher-doped collector junctions, leading to increased collector-base junction capacitance.

Some conventional HBT structures typically include a polycrystalline extrinsic base region and polycrystalline base link region, where the polycrystalline base link region is formed during growth of the intrinsic base region and cannot be easily optimized independent of the intrinsic base region. Polycrystalline semiconductor material is typically more resistive (e.g., compared to otherwise equivalent monocrystalline semiconductor material) and such conventional HBT structures, therefore, have relatively higher base resistance.

In one or more embodiments described herein, an HBT device includes an extrinsic base region and a base link region that are formed from monocrystalline semiconductor material (e.g., monocrystalline silicon, as a non-limiting example). In accordance with various embodiments herein, formation of the base link region and the extrinsic base region using selective epitaxial growth of monocrystalline semiconductor material may be performed following formation of the intrinsic base region. In this way, base resistance of the HBT device may be advantageously reduced and the base link region may be more easily optimized independently of the intrinsic base region (e.g., compared to conventional HBTs that use polycrystalline extrinsic base regions and polycrystalline base link regions). In accordance with various embodiments, the formation of the monocrystalline extrinsic base region may be performed before, after, or during formation of emitter-base spacer layers/structures that are used to separate and/or isolate base regions of the HBT device from emitter regions of the HBT device.

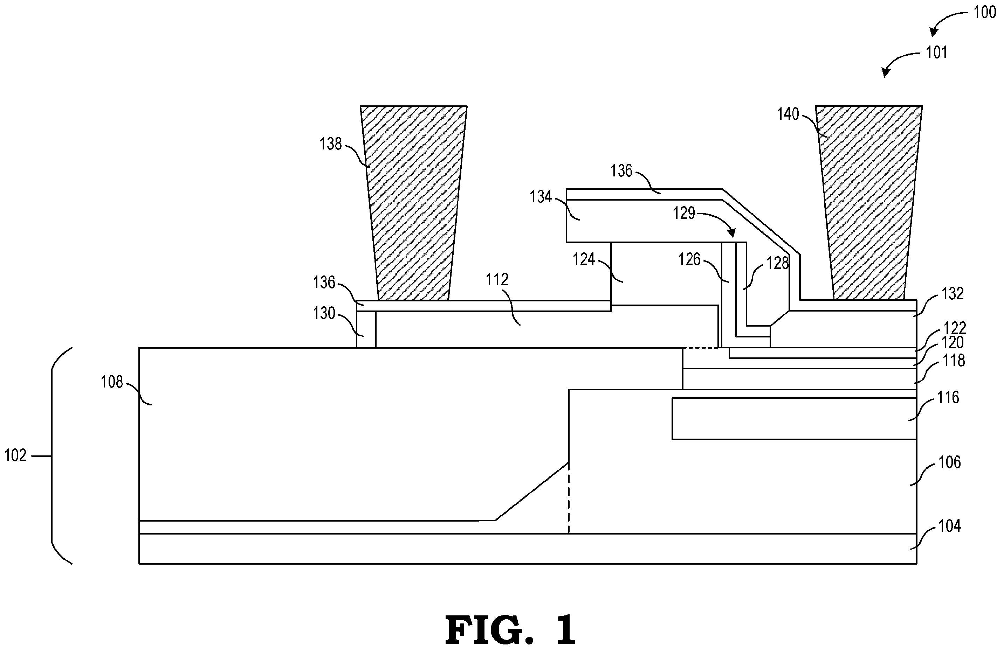

FIG. 1 is a cross-sectional side view 100 of a transistor device 101, in accordance with one or more embodiments. The transistor device 101 may include a base substrate 102 (sometimes referred to herein as the "substrate 102") that includes at least a buried layer 104, a collector region 106, an isolation region 108. The base substrate 102 may include one or more regions of semiconductor material (e.g., the buried layer 104, the collector region 106), where such regions of semiconductor material may include one or more of silicon (Si), germanium (Ge), silicon germanium (SiGe), gallium arsenide (GaAs), gallium phosphide (GaP), indium gallium phosphide (InGaP), indium phosphide (InP), gallium nitride (GaN), aluminum nitride (AlN), indium nitride (InN), silicon carbide (SiC), sapphire, or other suitable materials. In some embodiments, one or more regions of semiconductor material (e.g., the buried layer 104, the collector region 106) of the base substrate 102 may include semiconductor regions that are formed via ion implantation or that are grown via epitaxial growth. In one or more embodiments, the base substrate 102 may be a Silicon on Insulator (SOI) substrate that includes a buried oxide layer disposed between a base silicon substrate and a top silicon layer.

It should be understood that only a portion of the base substrate 102 is shown in the present example. For example, elements that may be included in the base substrate 102 and that are not shown here may include additional semiconductor regions (as described above), backside metallization (e.g., a reference plane), and/or one or more metallized through-substrate vias.

In one or more embodiments, the transistor device 101 is a double poly self-aligned selective epitaxial growth (DPSA-SEG) heterojunction bipolar transistor (HBT) device having a base region, a collector region, and an emitter region. The base region may include an extrinsic base region and an intrinsic base region. In one or more embodiments, the transistor device 101 may be an HBT that includes the collector region 106, an intrinsic base region 120 (sometimes referred herein to as the "monocrystalline intrinsic base region 120," "monocrystalline intrinsic base layer 120", or "intrinsic base layer 120") that is disposed over the collector region 106, an extrinsic base region 112 (sometimes referred to herein as the "monocrystalline extrinsic base region 112," "monocrystalline extrinsic base layer 112", or "extrinsic base layer 112") that partially overlaps the collector region 106 and at least partially overlaps the isolation region 108, a monocrystalline emitter region 132 (sometimes referred to herein as the "monocrystalline emitter layer 132") that is disposed over the intrinsic base region 120, and a polycrystalline emitter region 134 (sometimes referred to herein as the "polycrystalline emitter layer 134"). In one or more embodiments, the collector region 106, the intrinsic base region 120, the extrinsic base region 112, and the emitter regions 132 and 134 may include one or more of Si, Ge, SiGe, or silicon-germanium-carbon (SiGeC). In one or more embodiments, the monocrystalline emitter region 132 is formed from monocrystalline silicon and the polycrystalline emitter region 134 is formed from polycrystalline silicon. In one or more embodiments, the collector region 106, the intrinsic base region 120, the extrinsic base region 112, and the emitter region 132 may include one or more of Si, Ge, SiGe, GaAs, GaN, AlN, InN, InGaP, and/or other suitable semiconductor materials. The intrinsic base region 120 and the extrinsic base region 112 may each be formed from monocrystalline semiconductor material (such as monocrystalline silicon for the extrinsic base region 112 and monocrystalline silicon germanium for the intrinsic base region 120, as non-limiting examples), and a base link region connecting the intrinsic base region 120 to the extrinsic base region 112 may also be formed from the monocrystalline semiconductor material.

In one or more embodiments, the transistor device 101 may be configured as a npn transistor such that the collector region 106 and the emitter regions 132 and 134 include n-type semiconductor material and the intrinsic base region 120 and the extrinsic base region 112 may each include p-type semiconductor material. In such embodiments, the buried layer 104 may be a heavily doped N+ buried layer (e.g., with an n-type dopant concentration in a range of around 1e19 cm⁻³ to around 1e21 cm⁻³ although higher or lower dopant concentrations may be used). In other embodiments, the transistor device 101 may be configured as a pnp transistor such that the collector region 106 and the emitter regions 132 and 134 may include a p-type semiconductor and the intrinsic base region 120 and the extrinsic base region 112 may each include n-type semiconductor material. As used herein, the term "n-type semiconductor material" refers to a semiconductor material with a net electron concentration ranging from about 1e15 cm⁻³ to about 1e21 cm⁻³, though other higher or lower electron concentrations may be used. As used herein, the term "p-type semiconductor material" refers to a semiconductor material with a net hole concentration ranging from about 1e15 cm⁻³ to about 1e21 cm⁻³, though other higher or lower hole concentrations may be included. Herein, a parameter may be considered "about" or "approximately" equal to a given value or range of values if it is within +/- 10% of the given value or range of values, unless otherwise indicated.

In one or more embodiments, the collector region 106 may have a total thickness of between around 1,000 angstroms and around 3,000 angstroms. In one or more embodiments, the collector region 106 may have a total thickness of between around 100 angstroms and around 10,000 angstroms, though other thicknesses may be used. For embodiments in which the collector region 106 includes n-type semiconductor material (e.g., embodiments in which the transistor device 101 is a npn transistor), the collector region 106 may be doped with one or more of phosphorous (P), arsenic (As), antimony (Sb), lithium (Li), or other suitable n-type dopants. For embodiments in which the collector region 106 includes p-type semiconductor material (e.g., embodiments in which the transistor device 101 is a pnp transistor), the collector region 106 may be doped with one or more of carbon (C), boron (B), oxygen (O), or indium (In) or other suitable p-type dopants.

Herein, the term "n-type dopant" refers to material that, upon being integrated into (e.g., diffused through) a semiconductor crystal lattice structure, provides ("donates") free electrons in the lattice structure, such that electrons become the majority charge carrier in the lattice structure. Such n-type dopants include P, As, Sb, and Li as non-limiting examples. Herein, the term "p-type dopant" refers to material that are electron acceptors and that, upon being integrated into (e.g., diffused through) a semiconductor crystal lattice structure, introduce holes (sometimes referred to as "electron holes") in the lattice structure, such that holes become the majority charge carrier in the lattice structure. Such p-type dopants include B, Al, and In as non-limiting examples.

In one or more embodiments, regardless of the dopant type (n-type or p-type) of the collector region 106, at least a portion of the collector region 106 may be doped to have a dopant concentration of between about 5e18 cm⁻³ and about 5e20 cm⁻³, although other higher or lower dopant concentrations may be used. In one or more embodiments, the collector region 106 may include multiple doped regions, each having respectively different doping concentrations (e.g., within the previously described range of dopant concentrations or another suitable range of dopant concentrations). For example, the collector region 106 may include an implanted region 116, which may be a selectively implanted collector (SIC) region formed via ion implantation (e.g., self-aligned to an emitter window, as described in more detail below). In one or more embodiments, regardless of dopant type, the implanted region 116 may have a dopant concentration in a range of around 1e16 cm⁻³ to around 1e19 cm⁻³ although higher or lower dopant concentrations may be used. For example, the dopant concentration of the implanted region 116 may be selected to achieve a desired collector-base junction breakdown voltage. For example, the collector region 106 may have a dopant concentration that is between that of the buried layer 104 and the implanted region 116. In one or more embodiments, the implanted region 116 may be omitted, in which case the collector region 106 extends into the area in which the implanted region 116 is shown to be disposed in the present example. The collector region 106 may be coupled to a collector electrode (not shown).

The isolation region 108 may be disposed laterally adjacent to the collector region 106, such that a sidewall (i.e., side surface) of the isolation region 108 is in direct contact with a sidewall (i.e., side surface) of the collector region 106. In one or more embodiments, a portion of the isolation region 108 may extend over a portion of the collector region 106. In one or more embodiments, the isolation region 108 may include one or more of silicon dioxide (SiO₂), tetraethyl orthosilicate (TEOS), silicon nitride (SiN), silicon oxynitride (SiON), aluminum oxide (Al₂O₃), aluminum nitride (AlN), or other suitable dielectric material(s). The buried layer 104 may be disposed below the collector region 106 and the isolation region 108, and the buried layer 104 may be separated from the isolation region 108 by the collector region 106 (and/or other semiconductor material that may be disposed adjacent to the collector region 106).

A launcher layer 118 (sometimes referred to as a "semiconductor launcher layer 118" or as a "buffer layer 118") may be formed over the collector region 106 (e.g., directly on an upper surface of the collector region 106 or directly on the implanted region 116 if present). In one or more embodiments, the launcher layer 118 may include a low-doped (e.g., between around 1e16 cm⁻³ and about 1e18 cm⁻³, although other higher or lower dopant concentrations may be used) or undoped semiconductor material (e.g., silicon). The launcher layer 118 may have the same doping type (e.g., n-type or p-type) as the collector region 106, for embodiments in which the launcher layer 118 is doped. The launcher layer 118 may be configured to increase the velocity of electrons injected into the collector region 106 in one or more embodiments. In one or more embodiments, the launcher layer 118 may be an undoped monocrystalline silicon layer that is epitaxially grown on the collector region 106.

The intrinsic base region 120 may be formed over the collector region 106 (e.g., epitaxially grown directly on the launcher layer 118). In one or more embodiments, the intrinsic base region 120 is formed using Si_{1-X}Ge_{X} where X is the Ge mole fraction. In one or more embodiments, one or more portions of the intrinsic base region 120 may have a narrower bandgap than the emitter regions 132 and 134 and the collector region 106. In one or more embodiments, the bandgap of the one or more portions of the intrinsic base region 120 may be adjusted by changes in the Ge mole fraction. In one or more embodiments, the Ge mole fraction, X, may vary between about 0.05 and about 0.3 though other larger or smaller values of X may be used. In one or more embodiments, the value of the Ge mole fraction may be constant throughout the intrinsic base region 120. In still other embodiments, the bandgap of the intrinsic base region 120 may be continuously graded. In these embodiments, the material of the intrinsic base region 120 (e.g., Si_{1-X}Ge_{X}) may be graded by forming an upper portion of the intrinsic base region 120 with a wider bandgap and continuously reducing to a narrower bandgap in a lower portion of the intrinsic base region 120.

In one or more embodiments, a SiGe:C collector-base spacer (not shown) may be formed between intrinsic base region 120 and the launcher layer 118. The SiGe:C collector-base spacer may be undoped. In one or more embodiments, a SiGe:C base-emitter spacer (not shown) may be formed on the intrinsic base region 120 (e.g., between the intrinsic base region 120 and the emitter cap layer 122). The SiGe:C base-emitter spacer may be doped or may be undoped, according to various embodiments. In one or more embodiments, the intrinsic base region 120 may include boron-doped SiGe:C. In one or more such embodiments, the SiGe:C material of any of the collector-base spacer, base-emitter spacer, and the intrinsic base region 120 may have respective carbon content of between 0.01% and 0.1% and germanium content of around 30%. In such embodiments, the carbon content of the SiGe:C material of any of the collector-base spacer, the base-emitter spacer, and/or the intrinsic base region 120 may prevent or reduce undesirable diffusion of dopant impurities out of the intrinsic base region 120.

In one or more embodiments in which the transistor device 101 is a pnp transistor, the intrinsic base region 120 may include n-type semiconductor material, such as semiconductor material doped with P, As, Sb, Li, or another suitable n-type dopant. In one or more embodiments in which the transistor device 101 is a npn transistor, the intrinsic base region 120 may include p-type semiconductor material, such as semiconductor material doped with B, Al, In, or another suitable p-type dopant. The dopant concentration of the intrinsic base region 120 may be in a range of around 1e18 cm⁻³ to 1e21 cm⁻³, although higher or lower dopant concentrations may be used.

The extrinsic base region 112 may be formed over the base substrate 102. As shown in the present example, a first portion of the extrinsic base region 112 may be formed directly over the isolation region 108 and a second portion of the extrinsic base region 112 may be formed directly over the collector region 106. In one or more embodiments in which the transistor device 101 is a pnp transistor, the extrinsic base region 112 may include n-type semiconductor material, such as semiconductor material doped with P, As, Sb, Li, or another suitable n-type dopant. In one or more embodiments in which the transistor device 101 is a npn transistor, the extrinsic base region 112 may include p-type semiconductor material, such as semiconductor material doped with B, Al, In, or another suitable p-type dopant. The dopant concentration of the extrinsic base region 112 may be in a range of around 1e20 cm⁻³ to 5e21 cm⁻³, although higher or lower dopant concentrations may be used.

In one or more embodiments, one or more dielectric layers, such as a passivation layer (not shown), may be interposed between the extrinsic base region 112 and the base substrate 102. The passivation layer may at least partially separate and electrically insulate the extrinsic base region 112 from the collector region 106. For example, the passivation layer may be formed from dielectric material, such as SiO₂, TEOS, SiN, SiON, Al₂O₃, AlN, or other suitable dielectric material(s). In one or more embodiments, the passivation layer may be formed from a dielectric material that is the same as that of the isolation region 108. In one or more other embodiments, the passivation layer may be formed from a dielectric material that is different from that of the isolation region 108. For example, the isolation region 108 may be formed from TEOS and the passivation layer may be formed from nitride material (e.g., AlN, SiON, or SiN as non-limiting examples). The extrinsic base region 112 may be coupled to the intrinsic base region 120 by a base link region.

The extrinsic base region 112 may be coupled to a base electrode 138 via a contact layer 136, which may be formed using one or more of titanium-tungsten (TiW), titanium tungsten nitride (TiWN), tungsten silicide (WSi), cobalt silicide (CoSi), platinum silicide (PtSi), nickel platinum silicide (NiPtSi), or one or more other suitable material(s). In one or more embodiments, the contact layer 136 may be formed via silicidation. The base electrode 138 may be formed from copper, aluminum, tungsten, or another suitable conductive material, for example.

The monocrystalline emitter region 132 may be formed over the intrinsic base region 120. The polycrystalline emitter region 134 may be formed over portions of the intrinsic base region 120 and the extrinsic base region 112. In one or more embodiments in which the transistor device 101 is a npn transistor, the emitter regions 132 and 134 may be formed using n-type semiconductor material, such as semiconductor material doped with one or more of P, As, Sb, Li, or another suitable n-type dopant. In one or more embodiments in which the transistor device 101 is a pnp transistor, the emitter regions 132 and 134 may be formed using p-type semiconductor material, such as semiconductor material doped with one or more of B, Al, In, or another suitable p-type dopant. The dopant concentration of the emitter region 132 may be in a range of around 1e19 cm⁻³ to 3e21 cm⁻³, although higher or lower dopant concentrations may be used.

In one or more embodiments, the emitter region 132 includes monocrystalline semiconductor material (e.g., monocrystalline silicon) and the emitter region 134 includes polycrystalline semiconductor material (e.g., polycrystalline silicon). In one or more embodiments, the emitter regions 132 and 134 may each have a thickness of between about 100 angstroms around 1000 angstroms, although it should be understood that other suitable thicknesses may be used. The emitter region 132 may be coupled to an emitter electrode 140 via the contact layer 136, which may be formed using one or more of TiW, TiWN, WSi, CoSi, PtSi, NiPtSi, or other suitable material(s). In one or more embodiments, the contact layer 136 may be formed via silicidation. The emitter electrode 140 may be formed from copper, aluminum, tungsten, or another suitable conductive material, for example.

An emitter cap layer 122 may be formed over (e.g., directly on) the intrinsic base region 120 and may be disposed beneath the monocrystalline emitter region 132. The emitter cap layer 122 may form a portion of the emitter-base junction. In one or more embodiments, the emitter cap layer 122 may be undoped. In or more other embodiments, the emitter cap may be doped with the same type of dopant (i.e., n-type or p-type) as the intrinsic base region 120 and may have a dopant concentration in a range of around 1e17 cm⁻³ to around 1e18 cm⁻³, although higher or lower dopant concentrations may be used.

A spacer structure 129 (sometimes referred to herein as the "dielectric spacer structure 129") formed from first and second spacer layers 126 and 128 may be disposed between the emitter regions 132 and 134 and the base regions 112 and 120. For example, the spacer structure 129 may be disposed over the monocrystalline intrinsic base layer 120 and under the polycrystalline emitter layer 134. For example, at least a portion of the spacer structure 129 may be disposed directly between the monocrystalline extrinsic base layer 112 and the monocrystalline emitter layer 132. The spacer structure 129 may separate and at least partially electrically isolate the emitter regions of the transistor device 101 from the base regions of the transistor device 101. As shown, the first and second spacer layers 126 and 128 (and, therefore, the spacer structure 129) have L-shaped or substantially L-shaped cross-sections. During fabrication of the transistor device 101, the monocrystalline extrinsic base region 112 is formed after forming some or all of the spacer structure 129.

A dielectric layer 124 (sometimes referred to herein as the "first dielectric layer 124") may be interposed directly between and in contact with the emitter region 134 and the extrinsic base region 112. The dielectric layer 124 may laterally contact the first spacer layer 126. The dielectric layer 124 and the first and second spacer layers 126 and 128 may provide electrical insulation between the emitter layers 132 and 134 and the base regions 112 and 120. The emitter region 134 may partially overhang the dielectric layer 124. In one or more embodiments, the first spacer layer 126 is formed from an oxide, such as SiO₂, TEOS, or Al₂O₃ as non-limiting examples. In one or more embodiments, the second spacer layer 128 is formed from a nitride, such as AlN, SiON, or SiN as non-limiting examples. In one or more embodiments, the dielectric layer 124 is formed from a nitride, such as AlN, SiON, or SiN as non-limiting examples.

In one or more embodiments, polycrystalline semiconductor material 130 may be disposed laterally adjacent (e.g., laterally contacting) the extrinsic base region 112. For example, the polycrystalline semiconductor material 130 may be remnant material that is left behind after etching of excess polycrystalline semiconductor material when forming the polycrystalline emitter region 134. In one or more other embodiments, the polycrystalline semiconductor material 130 may be removed another etch process following etching of the polycrystalline emitter region 134.

Conventional HBTs sometimes include polycrystalline extrinsic base regions with polycrystalline base link regions connecting the extrinsic base to the intrinsic base. However, achieving low base resistance is challenging in such conventional approaches, due to the relatively higher resistivity of polycrystalline semiconductor materials. In the transistor device 101 of the present example, each of the intrinsic base region 120, the extrinsic base region 112, and the base link region connecting the intrinsic base region 120 to the extrinsic base region 112 are formed from monocrystalline semiconductor material, such that the base resistance of the transistor device 101 is advantageously lower compared to conventional approaches that rely on polycrystalline extrinsic base regions and base link regions.

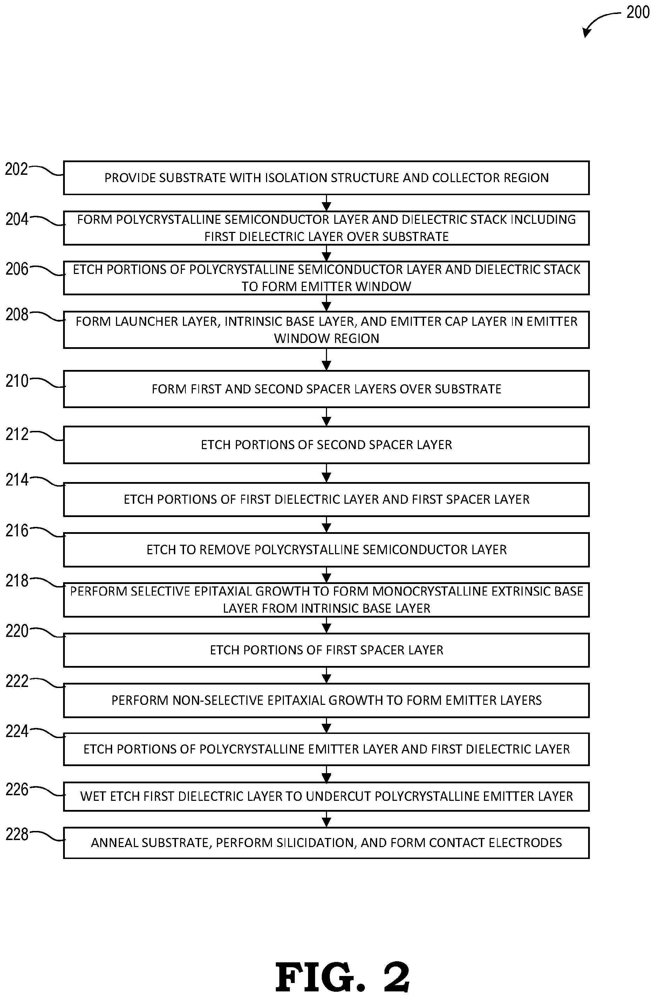

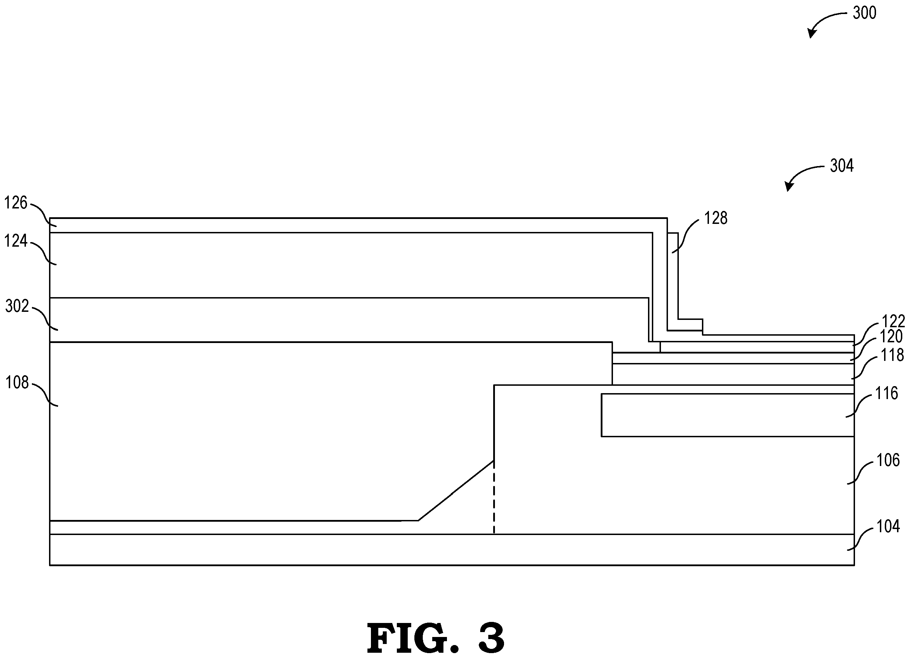

FIG. 2 is a process flow diagram depicting a method 200 for fabricating at least a portion of a transistor device (e.g., a HBT device), such as the transistor device 101 of FIG. 1, in accordance with various embodiments. For enhanced understanding, FIG. 2 may be viewed simultaneously with FIGS. 3-11, which are cross sectional views depicting the transistor device 101 of FIG. 1 at various stages of fabrication in accordance with various embodiments. The method 200 is described here with reference to elements of FIGS. 1 and 3-11, though it should be understood that this is intended to be illustrative and non-limiting.

Blocks 202, 204, 206, 208, and 210 are performed prior to the stage of fabrication 300 of FIG. 3, and are described here with reference to elements of the stage of fabrication 300 of FIG. 3. Referring first to block 202 of FIG. 2, the base substrate 102 is provided, which includes the buried layer 104, the collector region 106, and the isolation region 108. It should be understood that, in one or more embodiments, the base substrate 102 may include one or more layers of dielectric material (e.g., a passivation layer) formed over the isolation region 108 and collector region 106 at block 202.

The isolation region 108 may provide at least partial electrical isolation for the collector region 106. As described above, the present example shows only a portion of the base substrate 102, and it should be understood that the base substrate 102 may include additional portions (e.g., additional portions of the collector region 106 and the isolation region 108, silicon-on-insulator (SOI), backside metallization, through-silicon vias, and/or the like) not illustrated here. The semiconductor material of the collector region 106 may be doped with n-type dopant material or p-type dopant material prior to block 202, as described above.

Referring next to block 204 of FIG. 2, a polycrystalline semiconductor layer 302 is formed on an upper surface of the base substrate 102, and a dielectric stack is formed over the polycrystalline semiconductor layer. The dielectric stack may include a dielectric layer 124, which may be formed from nitride material, such as SiN, SiON, or AlN, as non-limiting examples. In one or more embodiments, the polycrystalline semiconductor layer 302 may be formed via non-selective epitaxial growth of polysilicon or poly-SiGe, as non-limiting examples.

Referring next to block 206 of FIG. 2, portions of the polycrystalline semiconductor layer 302 and the dielectric stack are etched to form an emitter window 304 over the collector region 106. An upper surface of the collector region 106 may be exposed via the emitter window. For example, the emitter window 304 may be formed using one or more etch processes, which may include one or more wet chemical etch processes, reactive ion etch (RIE) processes, or other suitable etch processes.

Referring next to block 208 of FIG. 2, a launcher layer 118, an intrinsic base layer 120, and an emitter cap layer 122 are formed over the collector region 106 of the base substrate 102 in the region of the emitter window 304. For example, the launcher layer 118 may be formed on an upper surface of the collector region 106 via selective epitaxial growth. Additional polycrystalline semiconductor material may be formed on the underside of polycrystalline semiconductor layer 302 during selective epitaxial growth of the launcher layer 118. For example, the intrinsic base layer 120 may be formed, via selective epitaxial growth, on an upper surface of the launcher layer 118 and in contact with a bottom surface of the additional polycrystalline semiconductor material that was formed on the polycrystalline semiconductor layer 302 during selective epitaxial growth of the launcher layer 118. For example, the emitter cap layer 122 may be formed on an upper surface of the intrinsic base layer 120 via selective epitaxial growth. As described above, the launcher layer 118, the intrinsic base layer 120, and the emitter cap layer 122 may each be formed from epitaxially-grown semiconductor material (e.g., SiGe, as a non-limiting example). In one or more embodiments, the implanted region 116 may also be formed (e.g., via ion implantation) at block 208, prior to formation of the launcher layer 118.

Herein, "non-selective epitaxial growth" of semiconductor material refers to a process (e.g., a "non-selective epitaxy" process) by which semiconductor material is epitaxially grown on any exposed non-crystalline (e.g., amorphous) surface and any exposed crystalline surface (e.g., on both dielectric material and semiconductor material). Herein, "selective epitaxial growth" of semiconductor material, for comparison, refers to a process (e.g., a "selective epitaxy" process) in which the use of material-selective chemistry increases the seeding time of the grown semiconductor material on non-crystalline (e.g., amorphous) surfaces to such an extent that the semiconductor material is grown on exposed crystalline surfaces and undergoes little or no growth non-crystalline surfaces. For non-selective epitaxy, the semiconductor material that is grown on monocrystalline surfaces has a monocrystalline structure, and the semiconductor material that is grown on non-crystalline surfaces or polycrystalline surfaces has a polycrystalline structure.

Referring next to block 210 of FIG. 2, a first spacer layer 126 and a second spacer layer 128 are formed over the base substrate 102. In one or more embodiments, the first spacer layer 126 may include oxide material (e.g., SiO₂, TEOS, Al₂O₃, or another suitable oxide material) and the second spacer layer 128 may include nitride material (e.g., SiN, SiON, AlN, or another suitable nitride material). The first spacer layer 126 may be deposited directly on the dielectric layer 124 and the emitter cap layer 122. The second spacer layer 128 may be deposited directly on the first spacer layer 126.

Referring next to block 212 of FIG. 2 and to FIG. 3, during a stage of fabrication 300, portions of the second spacer layer 128 are removed via one or more etch processes in conjunction with one or more photolithographic processes, such that a remaining portion of the second spacer layer 128 forms an L-shaped structure (i.e., part of the spacer structure 129 of FIG. 1). Portions of the first spacer layer 126 may be exposed via removal of the portions of the second spacer layer 128 at block 212. As shown, a portion of the first spacer layer 126 may remain covering the upper surface of the emitter cap layer 122 at block 212, thereby protecting the upper surface during one or more subsequent processing steps.

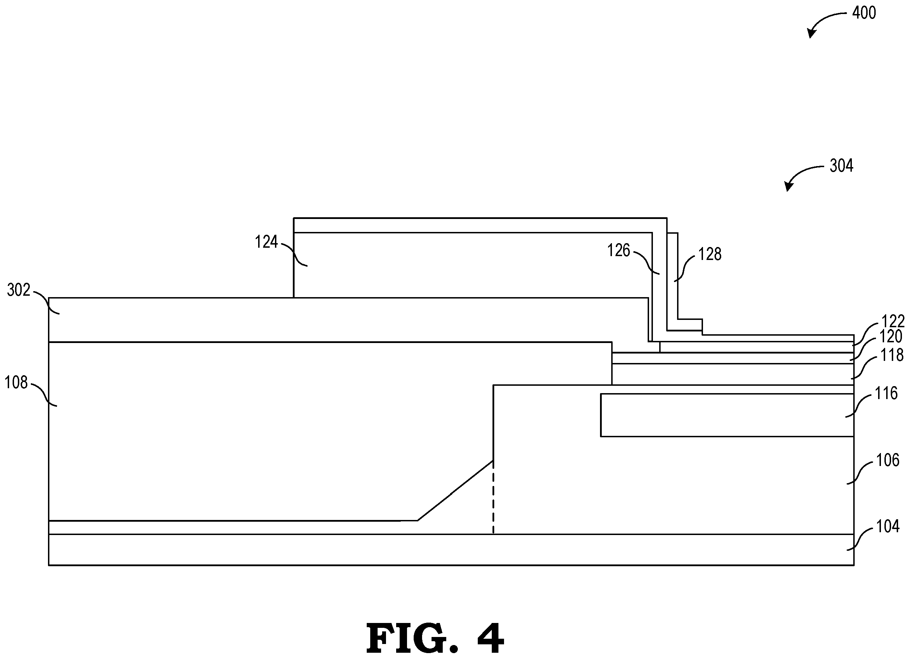

Referring next to block 214 of FIG. 2 and to FIG. 4, during a stage of fabrication 400, portions of the dielectric layer 124 and the first spacer layer 126 are removed via one or more anisotropic, patterned etch processes, which may be performed in conjunction with one or more photolithographic processes. Herein, an "anisotropic etch process"' refers to an etch process that is directionally dependent (e.g., the etch rate for the processes in a given direction is higher than the respective etch rates for the process in one or more other directions). Herein, for comparison, an "isotropic etch process" refers to an etch process that, for a given material, has an etch rate that is constant or substantially constant in all directions (e.g., i.e., the etch rate for the process is not directionally dependent).

For example, the portions of the first spacer layer 126 may be removed via a reactive ion etch (RIE) process, such as an oxide-selective RIE process. For example, the portions of the dielectric layer 124 may be removed via a RIE process, such as a nitride-selective RIE process. Removal of the portion of the dielectric layer 124 may expose part of an upper surface of the polycrystalline semiconductor layer 302. In one or more other embodiments, a portion of the polycrystalline semiconductor layer 302 may also be removed via a selective RIE process at block 214.

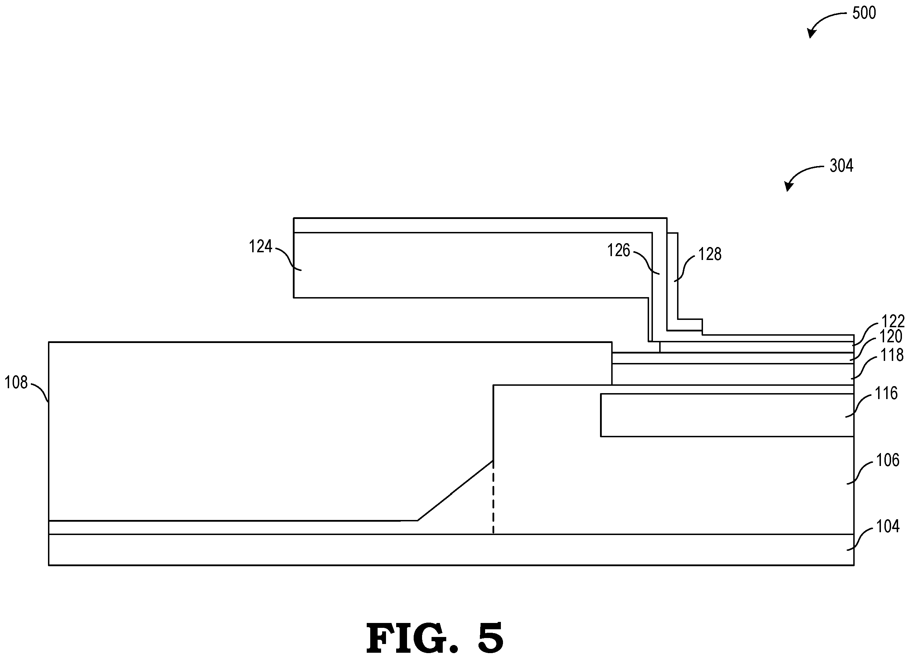

Referring next to block 216 of FIG. 2 and to FIG. 5, during a stage of fabrication 500, the polycrystalline semiconductor layer 302 is removed via an etch process. In one or more embodiments, a chemical etch process, using hydrogen chloride gas (HCl) as a non-limiting example, may be performed to remove the polycrystalline semiconductor layer 302. In one or more other embodiments, an RIE process may instead be performed to remove the polycrystalline semiconductor layer 302. In one or more embodiments, removal of the polycrystalline semiconductor layer 302 during the stage of fabrication 500 may include removal of the additional polycrystalline semiconductor material previously formed on the polycrystalline semiconductor layer 302 during formation of the launcher layer 118.

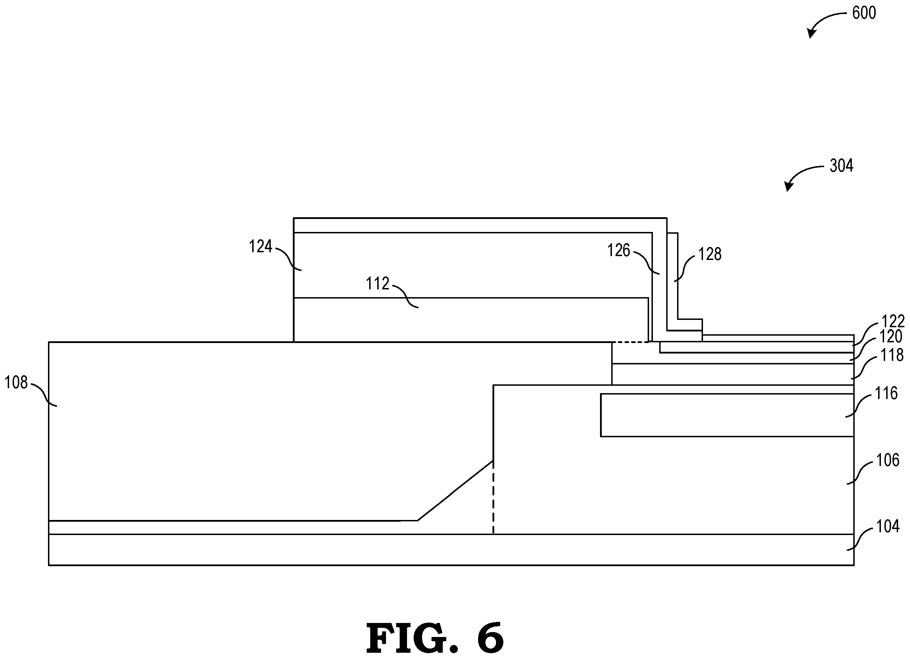

Referring next to block 218 of FIG. 2 and to FIG. 6, during a stage of fabrication 600, a monocrystalline extrinsic base region 112 is formed via selective epitaxial growth (i.e., grown from portions of the monocrystalline intrinsic base region 120 that were exposed during removal of the polycrystalline semiconductor layer 302 at block 216). In one or more embodiments, exposed surfaces of the substrate may be cleaned (e.g., using hydrofluoric acid (HF)) prior to selective epitaxial growth of the extrinsic base region 112. In one or more embodiments, dopants may be added in-situ (during growth of extrinsic base region 112) or added by way of ion implantation. In one or more embodiments in which the transistor device 101 is a pnp transistor, the extrinsic base region 112 may be doped with n-type dopants, such as P, As, Sb, Li, or another suitable n-type dopant. In one or more embodiments in which the transistor device 101 is a npn transistor, the extrinsic base region 112 may be doped with p-type dopants, such as B, Al, In, or another suitable p-type dopant. The dopant concentration of the extrinsic base region 112 may be in a range of around 1e20 cm⁻³ to 5e21 cm⁻³, although higher or lower dopant concentrations may be used.

In blocks 216 and 218, the polycrystalline semiconductor layer 302 is replaced by the monocrystalline extrinsic base region 112. This results in the extrinsic base and base link region (i.e., the region linking the extrinsic and intrinsic base regions) of the transistor device 101 being formed from monocrystalline, rather than polycrystalline, semiconductor material, which advantageously reduces extrinsic base resistance, and therefore overall base resistance, of the transistor device 101.

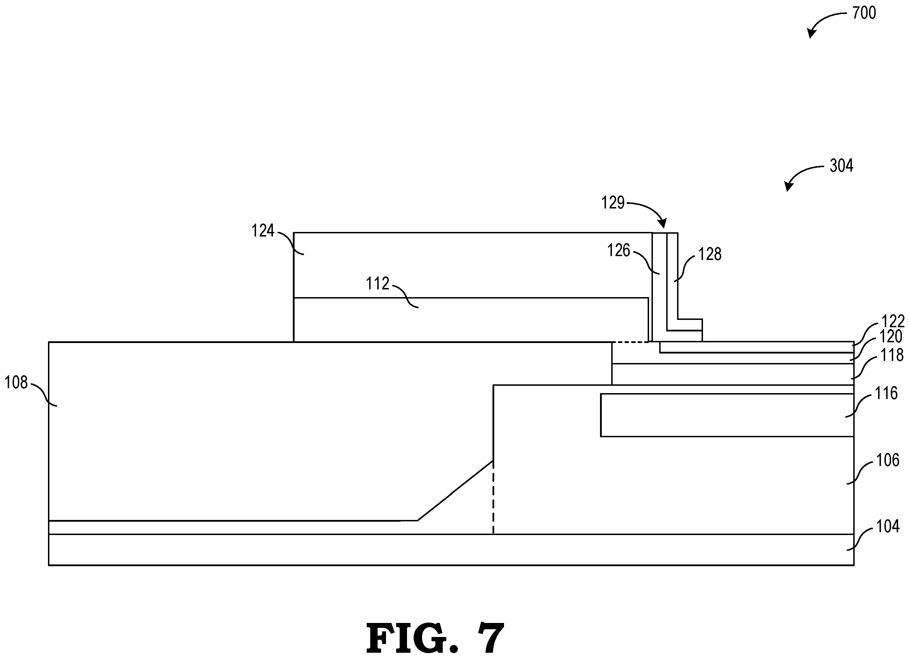

Referring next to block 220 of FIG. 2 and to FIG. 7, during a stage of fabrication 700, additional portions of the first spacer layer 126 are removed via an etch process, exposing upper surfaces of the emitter cap layer 122 and the dielectric layer 124. For example, these additional portions of the first spacer layer 126 may be removed using a wet chemical etch process, an RIE process, or another suitable etch process. In one or more embodiments, this etch process may be oxide-selective (e.g., a wet chemical etch using HF).

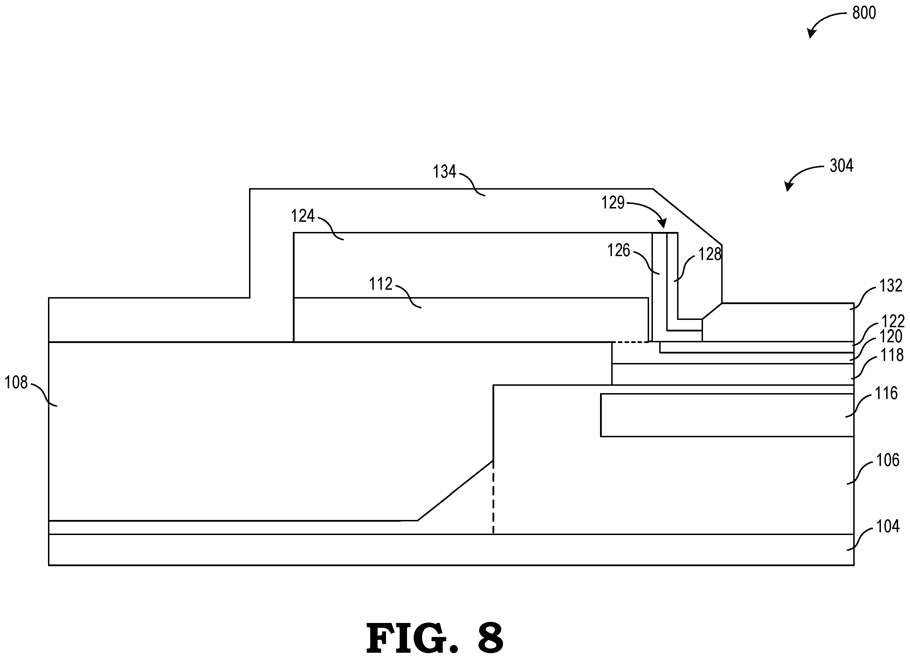

Referring next to block 222 of FIG. 2 and to FIG. 8, during a stage of fabrication 800, emitter regions 132 and 134 are grown over the substrate via a non-selective epitaxial growth process. The emitter region 132 may be grown from the emitter cap layer 122 and may be formed from monocrystalline semiconductor material (e.g., monocrystalline Si, Ge, SiGe, GaAs, GaN, AlN, InN, InGaP, and/or other suitable semiconductor materials). The emitter region 134 may be grown on dielectric surfaces, such as those of the isolation region 108 and the dielectric layer 124 and may be formed from polycrystalline semiconductor material (e.g., polycrystalline Si, Ge, SiGe, GaAs, GaN, AlN, InN, InGaP, and/or other suitable semiconductor materials). In one or more other embodiments, the emitter region 134 may be formed as an amorphous semiconductor layer, which would become polycrystalline after any subsequent thermal annealing.

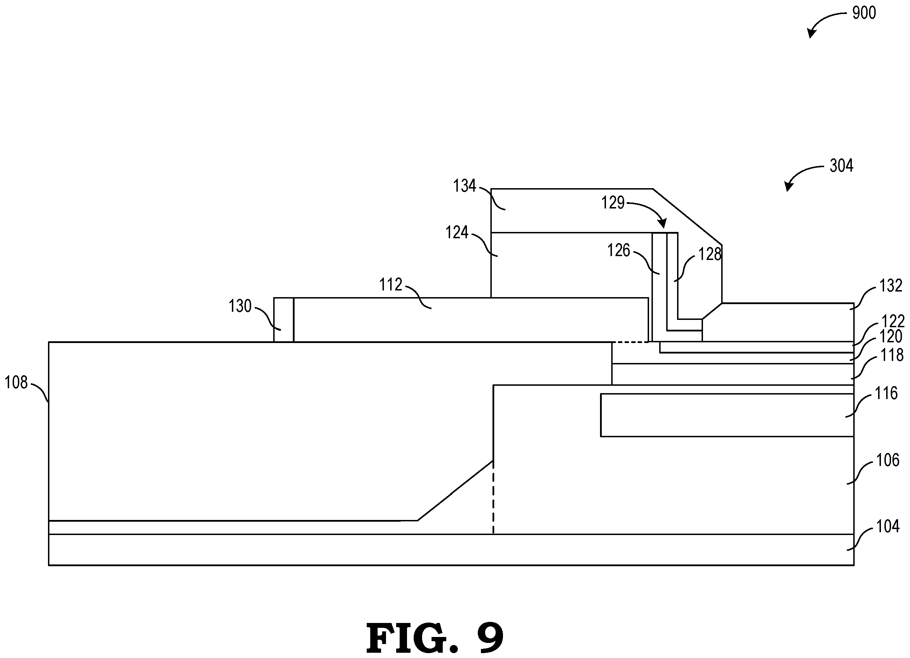

Referring next to block 224 of FIG. 2 and to FIG. 9, during a stage of fabrication 900, one or more patterned etch processes are performed to remove respective portions of emitter layer 134 and the dielectric layer 124 in conjunction with one or more photolithographic processes. In one or more embodiments, a portion of the emitter layer 134 disposed over the extrinsic base layer 112 and the isolation region 108 may be removed via a selective RIE process, then a portion of the dielectric layer 124 disposed on the upper surface of the extrinsic base layer 112 may be removed via a nitride-selective RIE process. As shown, removal of the portion of the dielectric layer 124 at block 224 may expose at least a potion of the upper surface of the extrinsic base layer 112. In one or more embodiments, remnant polycrystalline semiconductor material 130 that was not completely removed when etching the portion of the emitter layer 134 may remain laterally adjacent to the extrinsic base layer 112. The polycrystalline semiconductor material 130 may be removed during etching of the dielectric layer 124 at block 224, or maybe retained, in accordance with various embodiments.

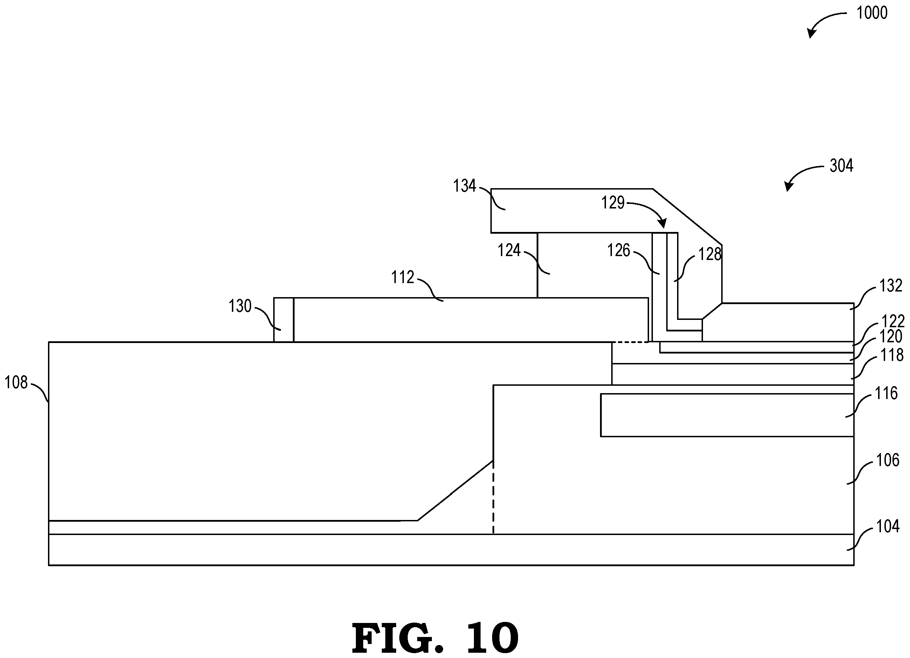

Referring next to block 226 of FIG. 2 and to FIG. 10, during a stage of fabrication 1000, a portion of the dielectric layer 124 is removed via a wet chemical etch process (e.g., a nitride-selective wet chemical etch process). This etch process may undercut the emitter region 134, such that a portion of the emitter region 134 overhangs the dielectric layer 124.

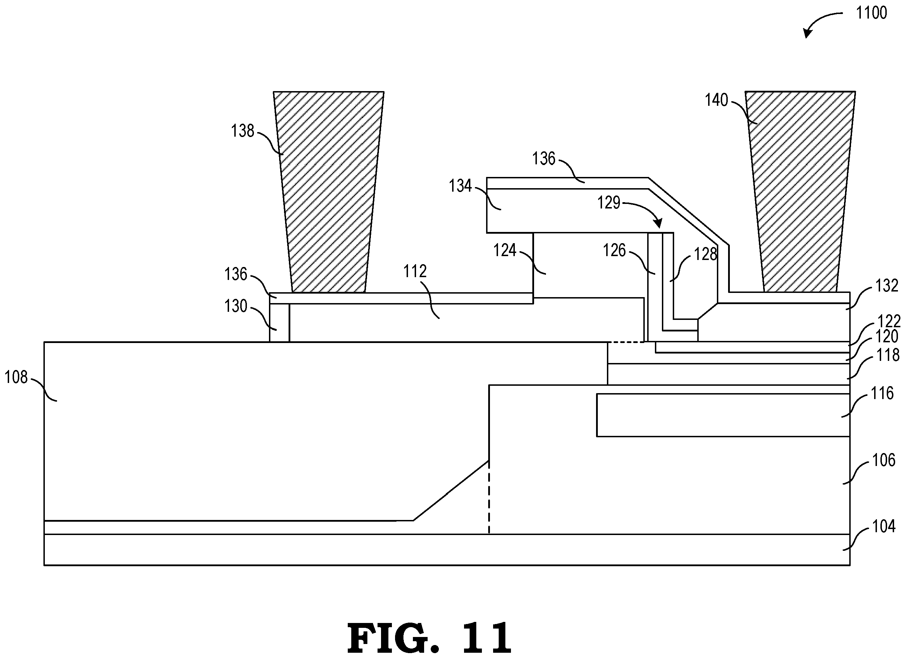

Referring next to block 228 of FIG. 2 and to FIG. 11, during a stage of fabrication 1100, the contact layer 136, the base electrode 138, and the emitter electrode 140 are formed. The contact layer 136 may be formed on the extrinsic base region 112 and on the emitter regions 132 and 134. The base electrode 138 may be formed over the extrinsic base region 112 directly on the contact layer 136. The emitter electrode 140 may be formed over the emitter region 132 directly on the contact layer 136. In one or more embodiments, the contact layer 136 is formed via a silicidation process. In one or more embodiments, the base electrode 138 and emitter electrode 140 are formed via one more metal deposition processes (e.g., sputtering, evaporation, plating, or another suitable metal deposition process) where the deposited metal is then patterned using suitable photolithography and etch processes. In one or more embodiments, the contact layer 136 includes one or more of TiW, TiWN, WSi, CoSi, PtSi, NiPtSi, or one or more other suitable material(s). In one or more embodiments, the base electrode 138 and the emitter electrode 140 may include one or more of copper, aluminum, tungsten, or another suitable conductive material. In one or more embodiments, the wafer on which the transistor device 101 is being formed may be annealed (e.g., heated to between 900 °C and 1100 °C) at block 228.

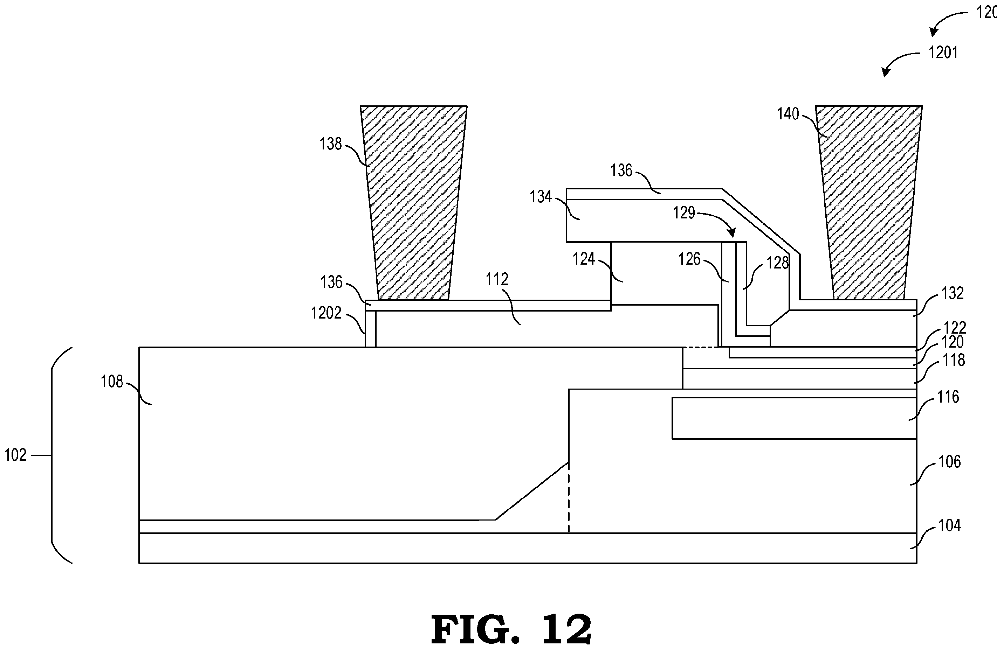

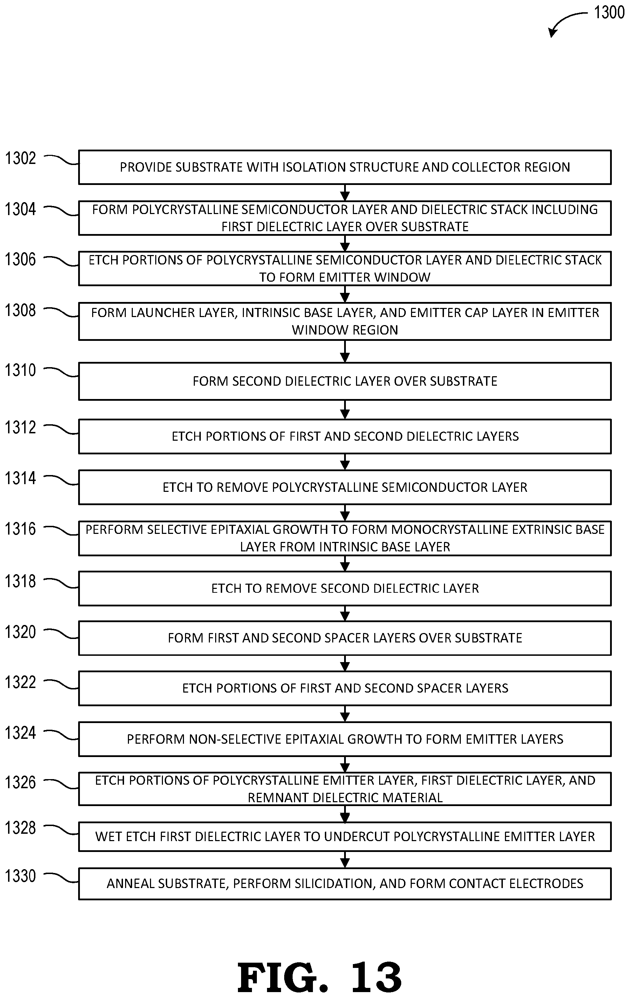

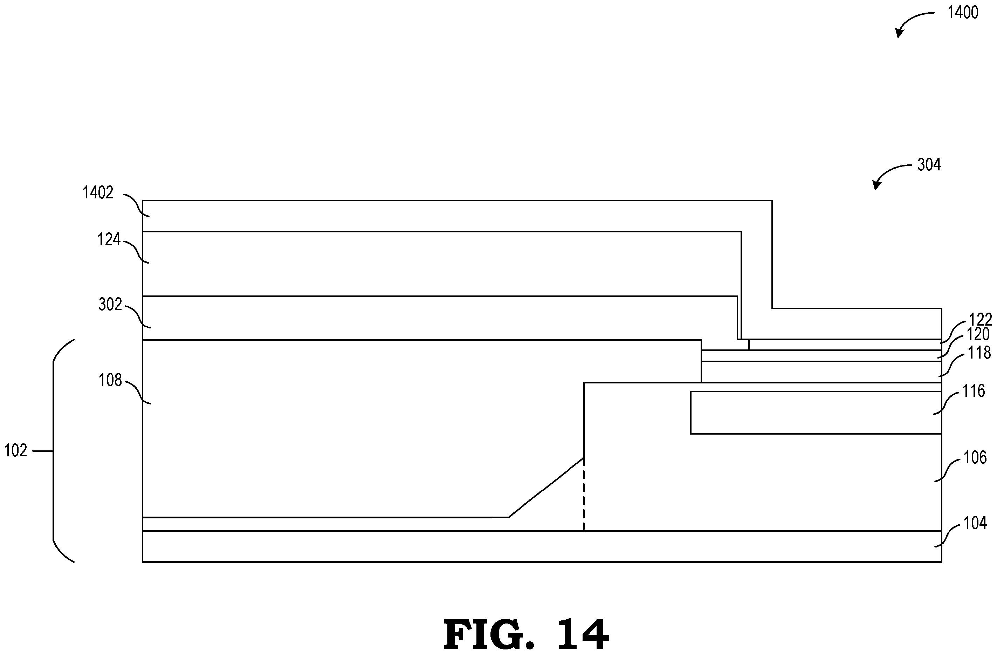

FIG. 12 shows a cross-sectional side view 1200 of a transistor device 1201, according to one or more embodiments. In one or more embodiments, the transistor device 1201 may be fabricated, at least in part, using the method 1300 of FIG. 13 and/or the steps of fabrication shown in FIGS. 14-24, described below. It should be noted that various features of the transistor device 1201 correspond to those described above in connection with the transistor device 101 of FIG. 1, with like reference numerals used here to denote similar elements, and descriptions of such elements are not necessarily repeated here for sake of brevity.

During fabrication of the transistor device 1201, the monocrystalline extrinsic base region 112 is formed prior to formation of the spacer structure 129. In one or more embodiments, forming the spacer structure 129 after forming the monocrystalline extrinsic base region 112 allows for a thicker dielectric (e.g., oxide) layer to be formed over the emitter cap layer 122 and intrinsic base region 120 during formation of the monocrystalline extrinsic base region 112, which provides improved protection of the emitter cap layer 122 and intrinsic base region 120 (e.g., during an HF pre-cleaning and subsequent epitaxial growth of the extrinsic base region 112), as will be described. Due to forming the spacer structure 129 after forming the monocrystalline extrinsic base region 112, dielectric material 1202 may remain adjacent to the extrinsic base region 112. As with the transistor device 101 of FIG. 1, the formation of the transistor device 1201 includes forming the monocrystalline extrinsic base region 112 to replace a polycrystalline semiconductor layer, providing advantageously lower extrinsic base resistance and overall base resistance.

FIG. 13 is a process flow diagram depicting a method 1300 for fabricating at least a portion of a transistor device (e.g., a HBT device), such as the transistor device 1201 of FIG. 12, in accordance with various embodiments. For enhanced understanding, FIG. 13 may be viewed simultaneously with FIGS. 14-24, which are cross sectional views depicting the transistor device 1201 of FIG. 12 at various stages of fabrication in accordance with various embodiments. The method 1300 is described here with reference to elements of FIGS. 12 and 14-24, though it should be understood that this is intended to be illustrative and non-limiting.

Blocks 1302, 1304, 1306, and 1308 of the method 1300 are similar to blocks 202, 204, 206, and 208 of FIG. 2, and descriptions thereof are not repeated here for sake of brevity. Referring next to block 1310 of FIG. 13 and to FIG. 14, during a stage of fabrication 1400, a second dielectric layer 1402 is formed over the substrate 102. The oxide layer 1402 may have a thickness of between around 200 angstroms and around 1,000 angstroms, as a non-limiting example. In one or more embodiments, the second dielectric layer 1402 may be deposited directly on the first dielectric layer 124 and the emitter cap layer 122. In one or more embodiments, the second dielectric layer 1402 may include oxide material (e.g., SiO₂, TEOS, Al₂O₃, or another suitable oxide material).

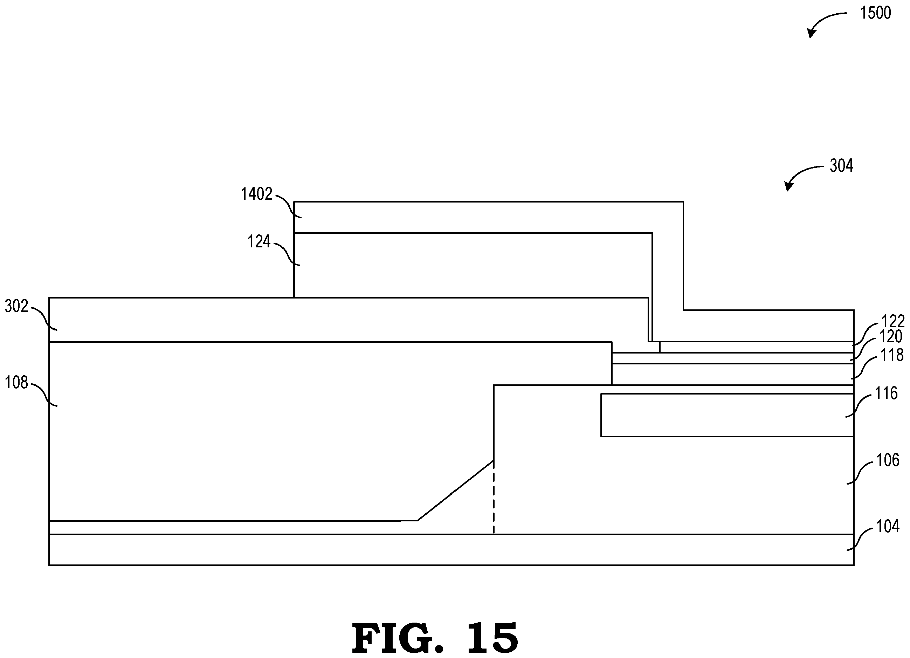

Referring next to block 1312 of FIG. 13 and to FIG. 15, during a stage of fabrication 1500, portions of the first dielectric layer 124 and the second dielectric layer 1402 are removed via one or more anisotropic, patterned etch processes, which may be performed in conjunction with one or more photolithographic processes. For example, the portions of the second dielectric layer 1402 may be removed via an oxide-selective RIE process, then the portions of the first dielectric layer 124 may be removed via a nitride-selective RIE process. Removal of the portion of the first dielectric layer 124 may expose part of an upper surface of the polycrystalline semiconductor layer 302. In one or more other embodiments, a portion of the polycrystalline semiconductor layer 302 may also be removed via a selective RIE process at block 1312.

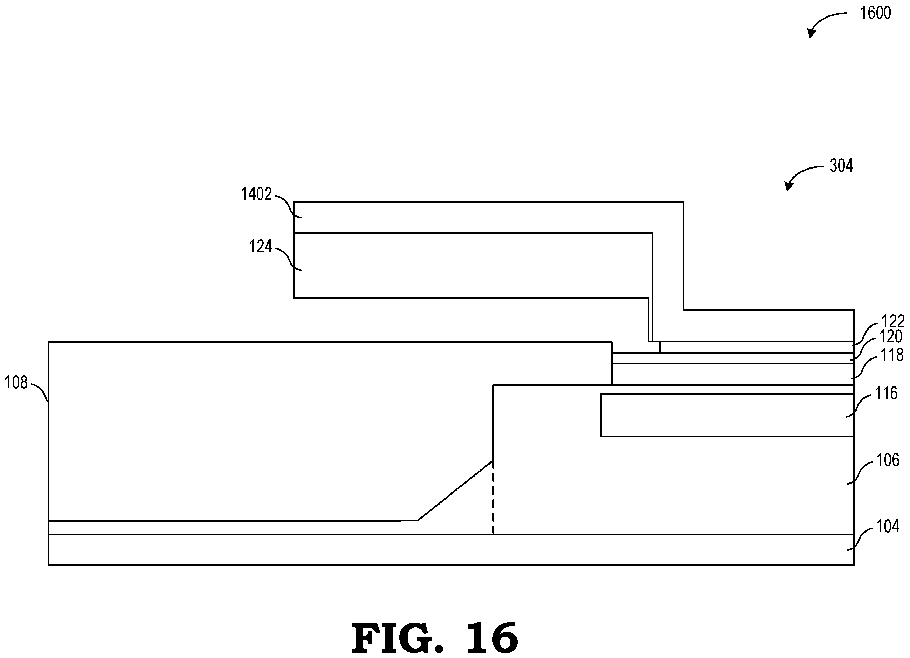

Referring next to block 1314 of FIG. 13 and to FIG. 16, during a stage of fabrication 1600, the polycrystalline semiconductor layer 302 is removed via an etch process. In one or more embodiments, a chemical etch process, using hydrogen chloride gas (HCl) as a non-limiting example, may be performed to remove the polycrystalline semiconductor layer 302. In one or more other embodiments, an RIE process may instead be performed to remove the polycrystalline semiconductor layer 302.

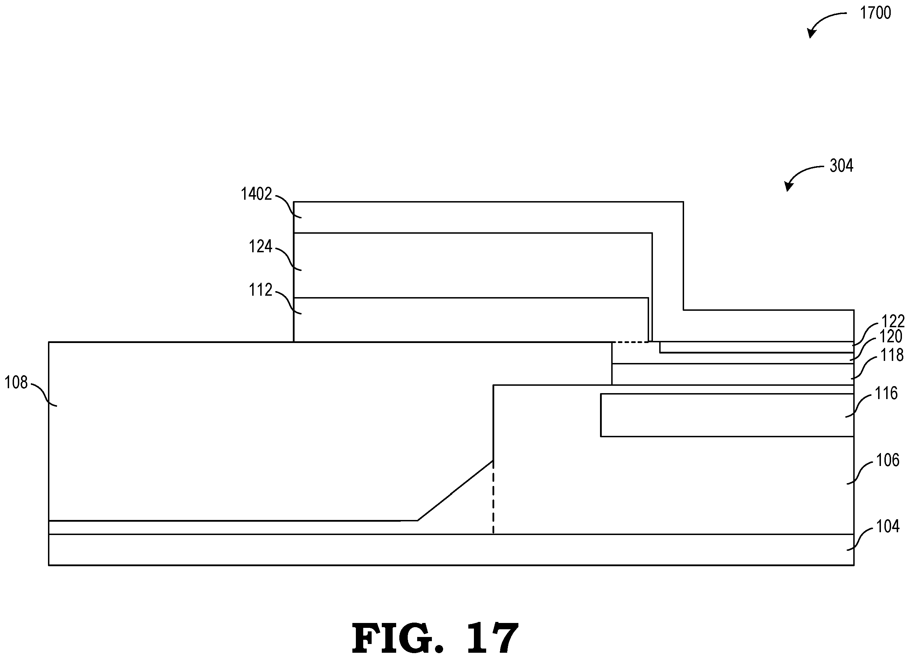

Referring next to block 1316 of FIG. 13 and to FIG. 17, during a stage of fabrication 1700, a monocrystalline extrinsic base region 112 is formed via selective epitaxial growth (i.e., grown from portions of the monocrystalline intrinsic base region 120 that were exposed during removal of the polycrystalline semiconductor layer 302 at block 1314). In one or more embodiments, exposed surfaces of the substrate may be cleaned (e.g., using hydrofluoric acid (HF)) prior to selective epitaxial growth of the extrinsic base region 112. In one or more embodiments, dopants may be added in-situ (during growth of extrinsic base region 112) or added by way of ion implantation. In one or more embodiments in which the transistor device 1201 is a pnp transistor, the extrinsic base region 112 may be doped with n-type dopants, such as P, As, Sb, Li, or another suitable n-type dopant. In one or more embodiments in which the transistor device 1201 is a npn transistor, the extrinsic base region 112 may be doped with p-type dopants, such as B, Al, In, or another suitable p-type dopant. The dopant concentration of the extrinsic base region 112 may be in a range of around 1e20 cm⁻³ to 5e21 cm⁻³, although higher or lower dopant concentrations may be used. The presence of the second dielectric layer 1402 in the emitter window 304 may protect the emitter cap layer 122 and intrinsic base region 120 during the HF pre-cleaning process and subsequent formation of the monocrystalline extrinsic base region 112 at this stage.

In blocks 1314 and 1316, the polycrystalline semiconductor layer 302 is replaced by the monocrystalline extrinsic base region 112. This results in the extrinsic base and base link region (i.e., the region linking the extrinsic and intrinsic base regions) of the transistor device 1201 being formed from monocrystalline, rather than polycrystalline, semiconductor material, which advantageously reduces extrinsic base resistance, and therefore overall base resistance, of the transistor device 1201.

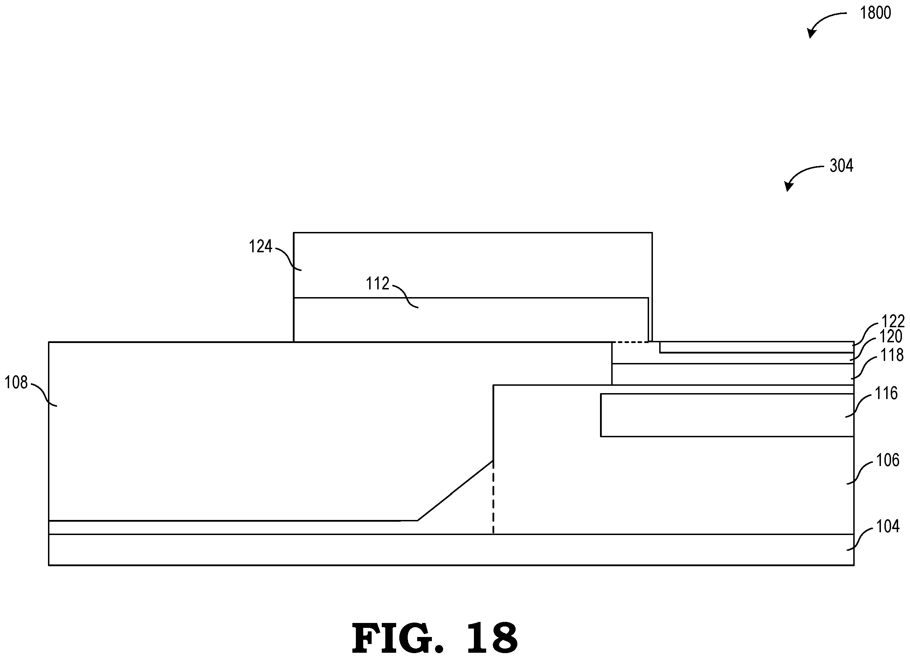

Referring next to block 1318 of FIG. 13 and to FIG. 18, during a stage of fabrication 1800, the second dielectric layer 1402 may be removed via a wet chemical etch process (e.g., an HF etch process).

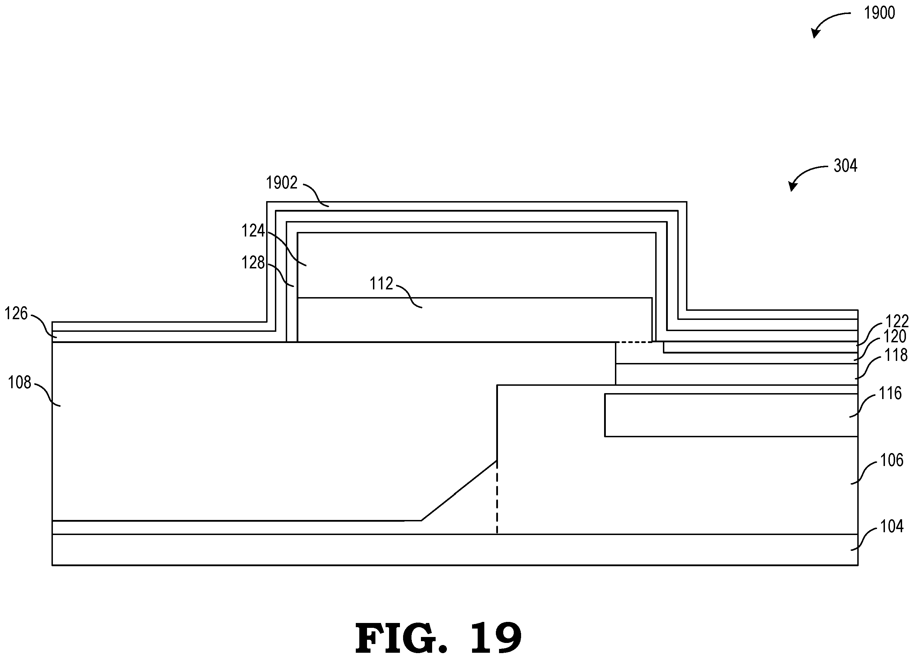

Referring next to block 1320 of FIG. 13 and to FIG. 19, during a stage of fabrication 1900, a first spacer layer 126, a second spacer layer 128, and a sacrificial dielectric layer 1902 are formed (e.g., in separate deposition steps) over the substrate 102.

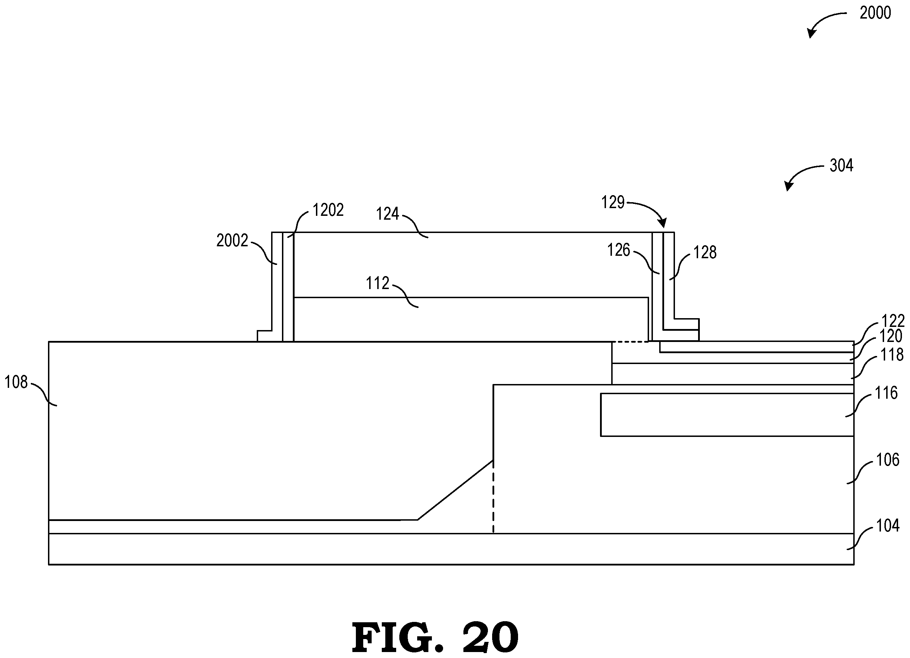

Referring next to block 1322 of FIG. 13 and to FIG. 20, during a stage of fabrication 2000, the sacrificial dielectric layer 1902 and portions of the first spacer layer 126 and the second spacer layer 128 are removed via one or more etch processes. In one or more embodiments, the portions of the second spacer layer 128 are removed via a nitride-selective RIE process, then the portions of the first spacer layer 126 are removed via an oxide-selective RIE process. These etch processes form the spacer structure 129 from remaining portions of the first spacer layer 126 and the second spacer layer 128. As shown, additional dielectric material 2002 may remain adjacent to side surfaces of the dielectric layer 124 and the extrinsic base region 112 after etching the second spacer layer 128, and additional dielectric material 1202 may remain adjacent to the side surfaces of the dielectric layer 124 and the extrinsic base region 112 after etching the first spacer layer 126.

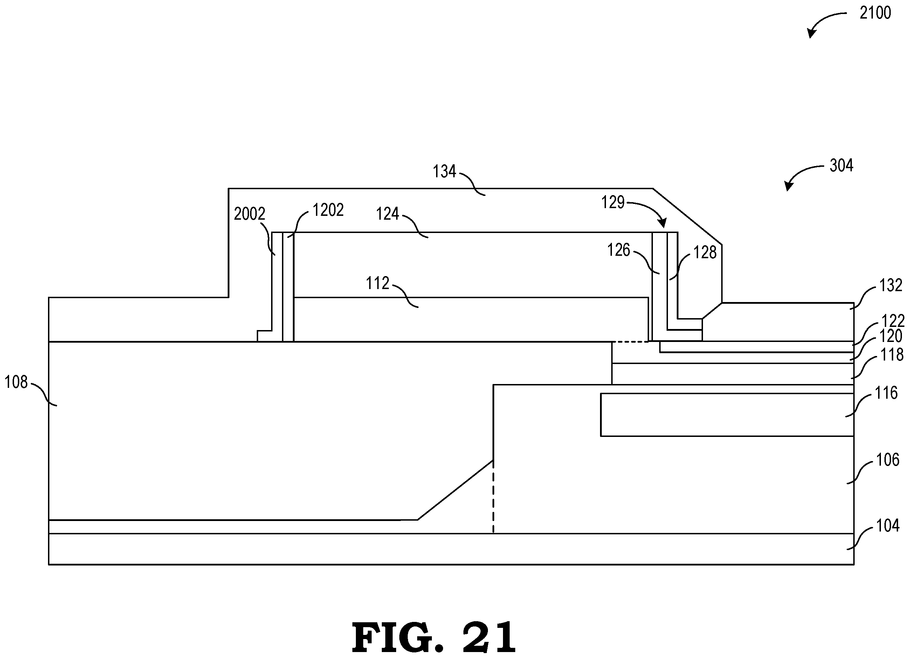

Referring next to block 1324 of FIG. 13 and to FIG. 21, during a stage of fabrication 2100, emitter regions 132 and 134 are formed over the substrate 102 via a non-selective epitaxial growth process. The emitter region 132 may be grown from the emitter cap layer 122 and may be formed from monocrystalline semiconductor material (e.g., monocrystalline Si, Ge, SiGe, GaAs, GaN, AlN, InN, InGaP, and/or other suitable semiconductor materials). The emitter region 134 may be grown on dielectric surfaces, such as those of the isolation region 108 and the dielectric layer 124 and may be formed from polycrystalline semiconductor material (e.g., polycrystalline Si, Ge, SiGe, GaAs, GaN, AlN, InN, InGaP, and/or other suitable semiconductor materials).In one or more other embodiments, the emitter region 134 may be formed as an amorphous semiconductor layer, which would become polycrystalline after any subsequent thermal annealing.

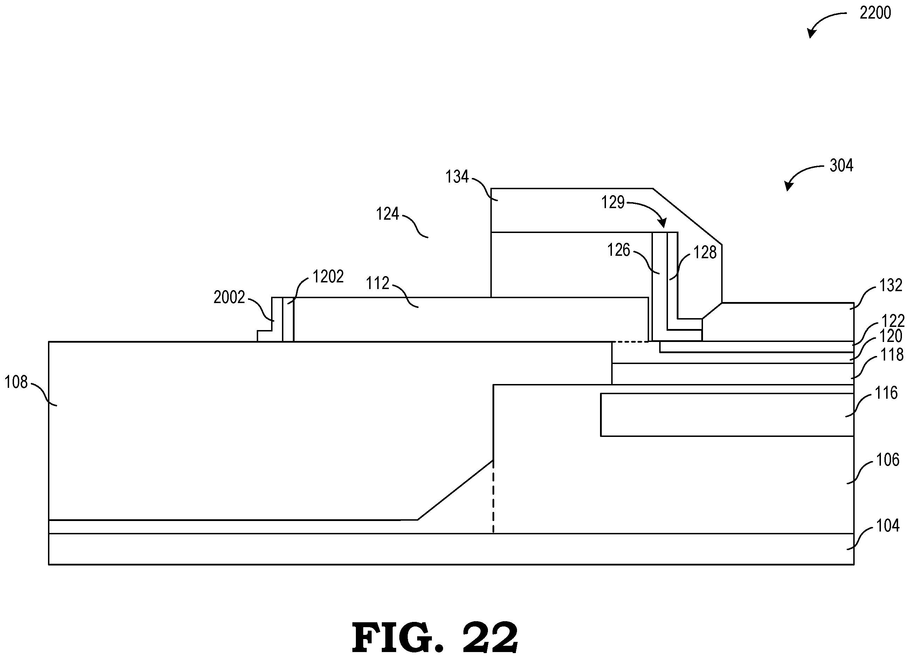

Referring next to block 1326 of FIG. 13 and to FIG. 22, during a stage of fabrication 2200, one or more patterned etch processes are performed to remove respective portions of emitter layer 134, the dielectric layer 124, and the dielectric material 1202 and 2002 in conjunction with one or more photolithographic processes. In one or more embodiments, a portion of the emitter layer 134 disposed over the extrinsic base layer 112 and the isolation region 108 may be removed via a selective RIE process, then a portion of the dielectric layer 124 disposed on the upper surface of the extrinsic base layer 112 and portions of the additional dielectric material 2002 and the additional dielectric material 1202 may be removed via a selective RIE process. As shown, removal of the portion of the dielectric layer 124 at block 1326 may expose at least a portion of the upper surface of the extrinsic base layer 112. In one or more embodiments, remnants of the dielectric material 1202 and 2002 and that are not completely removed by the etch processes of block 1326 may remain laterally adjacent to the extrinsic base layer 112.

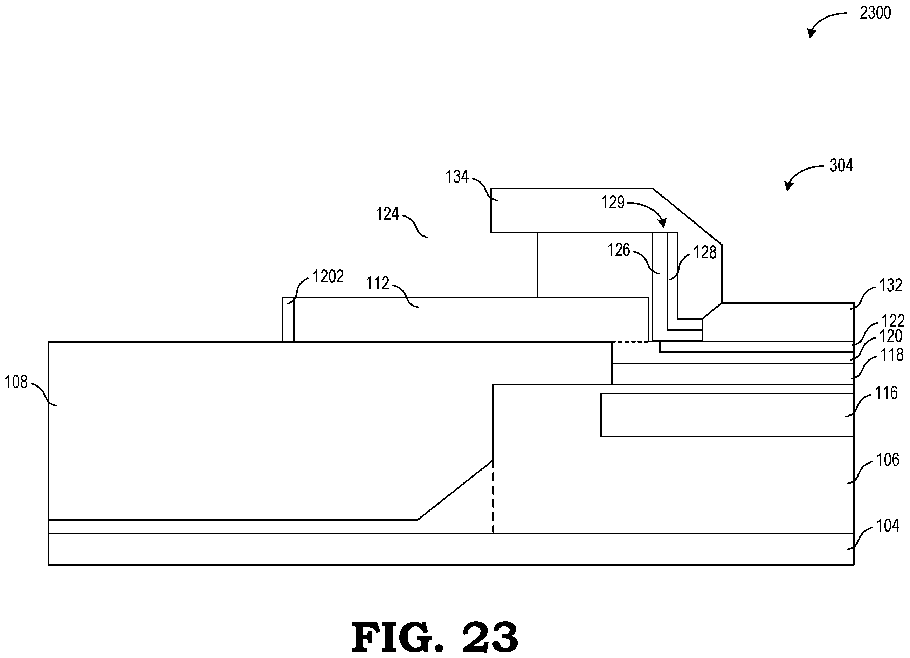

Referring next to block 1328 of FIG. 13 and to FIG. 23, during a stage of fabrication 2300, a portion of the dielectric layer 124 is removed via a wet chemical etch process (e.g., a nitride-selective wet chemical etch process). This etch process may undercut the emitter region 134, such that a portion of the emitter region 134 overhangs the dielectric layer 124. In one or more embodiments, the wet chemical etch process may remove remaining portions of the dielectric material 2002.

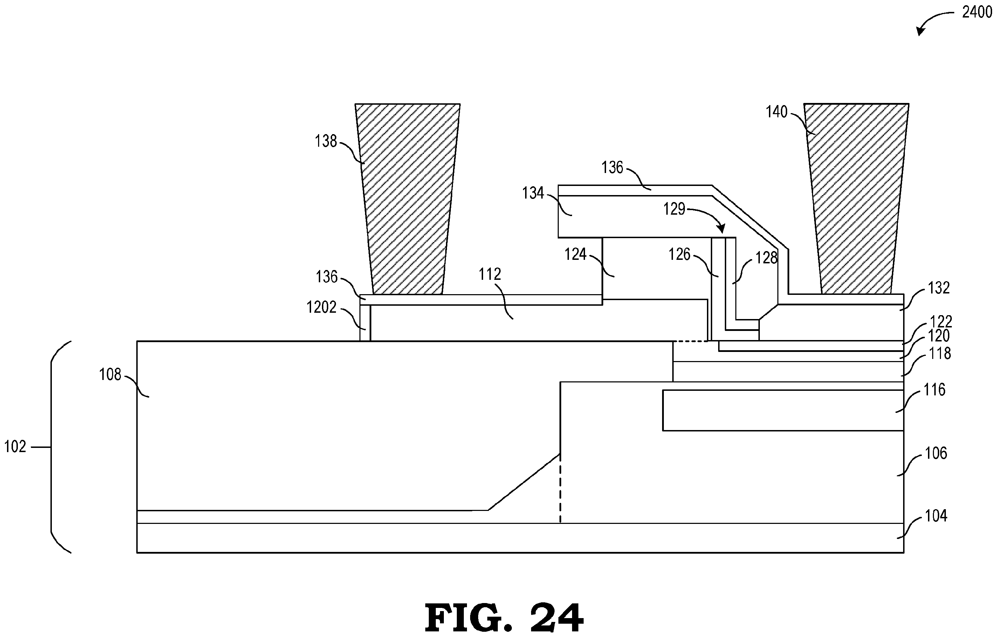

Referring next to block 1330 of FIG. 13 and to FIG. 24, during a stage of fabrication 2400, the contact layer 136, the base electrode 138, and the emitter electrode 140 are formed. The contact layer 136 may be formed on the extrinsic base region 112 and on the emitter regions 132 and 134. The base electrode 138 may be formed over the extrinsic base region 112 directly on the contact layer 136. The emitter electrode 140 may be formed over the emitter region 132 directly on the contact layer 136. In one or more embodiments, the contact layer 136 is formed via a silicidation process. In one or more embodiments, the base electrode 138 and emitter electrode 140 are formed via one more metal deposition processes (e.g., sputtering, evaporation, plating, or another suitable metal deposition process) where the deposited metal is then patterned using suitable photolithography and etch processes. In one or more embodiments, the contact layer 136 includes one or more of TiW, TiWN, WSi, CoSi, PtSi, NiPtSi, or one or more other suitable material(s). In one or more embodiments, the base electrode 138 and the emitter electrode 140 may include one or more of copper, aluminum, tungsten, or another suitable conductive material. In one or more embodiments, the wafer on which the transistor device 101 is being formed may be annealed (e.g., heated to between 900 °C and 1100 °C) at block 1330.

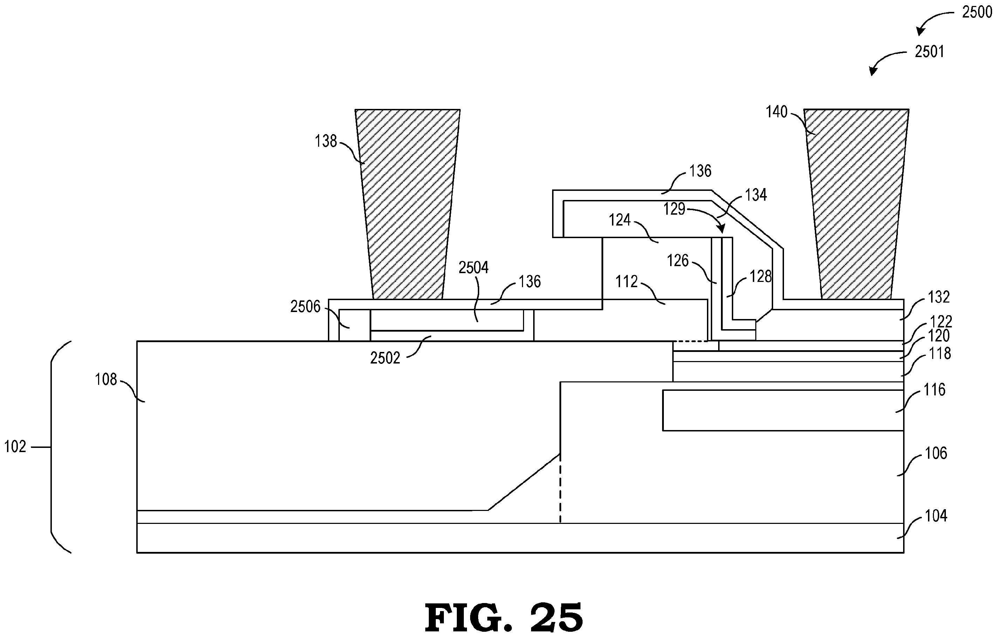

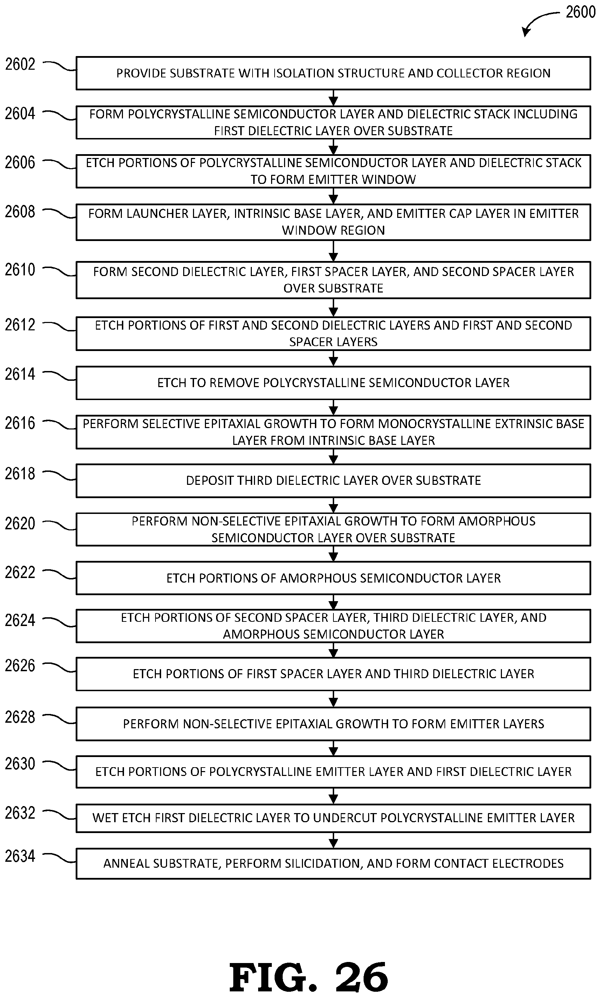

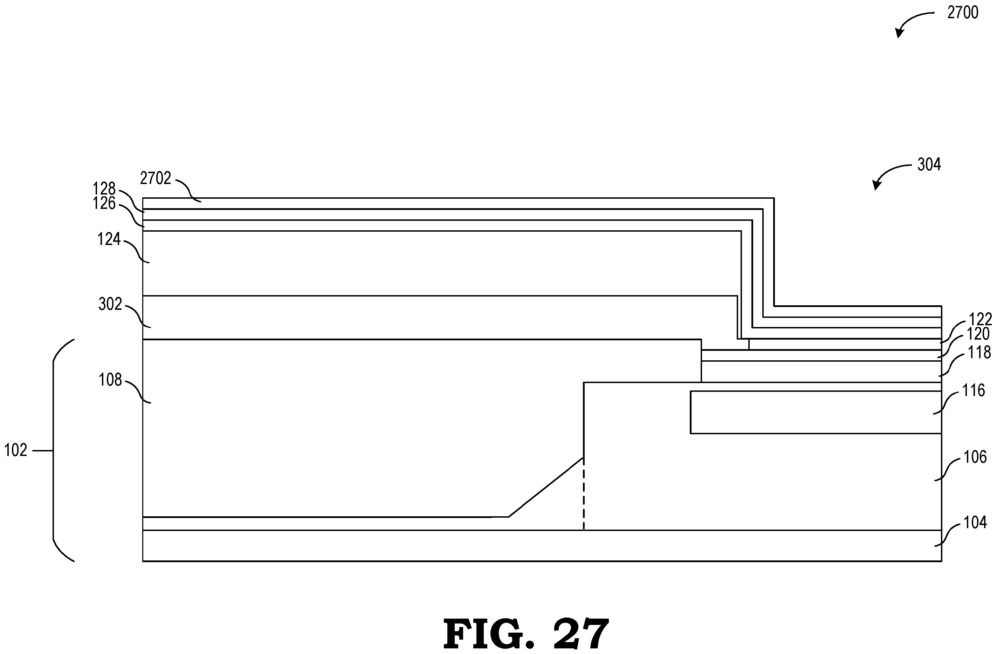

FIG. 25 shows a cross-sectional side view 2500 of a transistor device 2501, according to one or more embodiments. In one or more embodiments, the transistor device 2501 may be fabricated, at least in part, using the method 2600 of FIG. 26 and/or the steps of fabrication shown in FIGS. 27-39, described below. It should be noted that various features of the transistor device 2501 correspond to those described above in connection with the transistor device 101 of FIG. 1, with like reference numerals used here to denote similar elements, and descriptions of such elements are not necessarily repeated here for sake of brevity.

During fabrication of the transistor device 2501, the monocrystalline extrinsic base region 112 is formed as an intermediate processing step during formation of the spacer structure 129. For example, the monocrystalline extrinsic base region 112 may be formed after deposition of the first and second spacer layers 126 and 128 and before the first and second spacer layers 126 and 128 are etched to form the spacer structure 129. In one or more embodiments, forming the monocrystalline extrinsic base region 112 during formation of the spacer structure 129 results in multiple dielectric layers covering the emitter cap layer 122 and intrinsic base region 120 during formation of the monocrystalline extrinsic base region 112, which provides improved protection of the emitter cap layer 122 and intrinsic base region 120 (e.g., during an HF pre-cleaning and subsequent epitaxial growth of the extrinsic base region 112), as will be described.

In one or more embodiments, the monocrystalline extrinsic base region 112 is epitaxially grown to fill only a portion of the space under the dielectric layer 124, and amorphous semiconductor material 2504 (e.g., amorphous silicon, as a non-limiting example) and dielectric layer 2502 (e.g., oxide, as a non-limiting example) are formed (e.g., deposited and etched) to fill the remainder of that space. The amorphous semiconductor material 2504 may form a portion of the extrinsic base of the transistor device 2501, advantageously reducing the amount of material that must be epitaxially grown when forming the extrinsic base region 112 (i.e., the extrinsic base region can be smaller due to the amorphous semiconductor material 2504 acting as part of the extrinsic base). In one or more embodiments, polycrystalline semiconductor material 2506 may remain adjacent to side surfaces of the amorphous semiconductor material 2504 and the dielectric layer 2502 following a patterned etch of the polycrystalline emitter region 134.

The contact layer 136 may be in direct contact with upper surfaces of the extrinsic base region 112, the amorphous semiconductor material 2504, and the polycrystalline semiconductor material 2506. The contact layer 136 may bridge the gap between the amorphous semiconductor material 2504 and the extrinsic base region 112, where the gap is caused by the portion of the dielectric layer 2502 that is interposed between the amorphous semiconductor material 2504 and the extrinsic base region 112, such that the contact layer 136 electrically connects the amorphous semiconductor material 2504 to the extrinsic base region 112. As with the transistor device 101 of FIG. 1, the formation of the transistor device 2501 includes forming the monocrystalline extrinsic base region 112 to replace a polycrystalline semiconductor layer, providing advantageously lower extrinsic base resistance and overall base resistance.

FIG. 26 is a process flow diagram depicting a method 2600 for fabricating at least a portion of a transistor device (e.g., a HBT device), such as the transistor device 2501 of FIG. 25, in accordance with various embodiments. For enhanced understanding, FIG. 26 may be viewed simultaneously with FIGS. 27-39, which are cross sectional views depicting the transistor device 2501 of FIG. 25 at various stages of fabrication in accordance with various embodiments. The method 2600 is described here with reference to elements of FIGS. 25 and 27-39, though it should be understood that this is intended to be illustrative and non-limiting.

Blocks 2602, 2604, 2606, and 2608 of the method 2600 are similar to blocks 202, 204, 206, and 208 of FIG. 2, and descriptions thereof are not repeated here for sake of brevity. Referring next to block 2610 of FIG. 26 and to FIG. 27, during a stage of fabrication 2700, a second dielectric layer 2702, a first spacer layer126, and a second spacer layer 128 are formed (e.g., deposited) over the substrate 102. As shown, the first spacer layer 126 may be disposed in direct contact with respective surfaces of the first dielectric layer 124 and the emitter cap layer 122. The second spacer layer 128 may be formed directly on the first spacer layer 126. The second dielectric layer 2702 may be formed directly on the second spacer layer 128. In one or more embodiments, the first spacer layer 126 includes oxide material, the second spacer layer 128 includes nitride material, and the second dielectric layer 2702 includes oxide material.

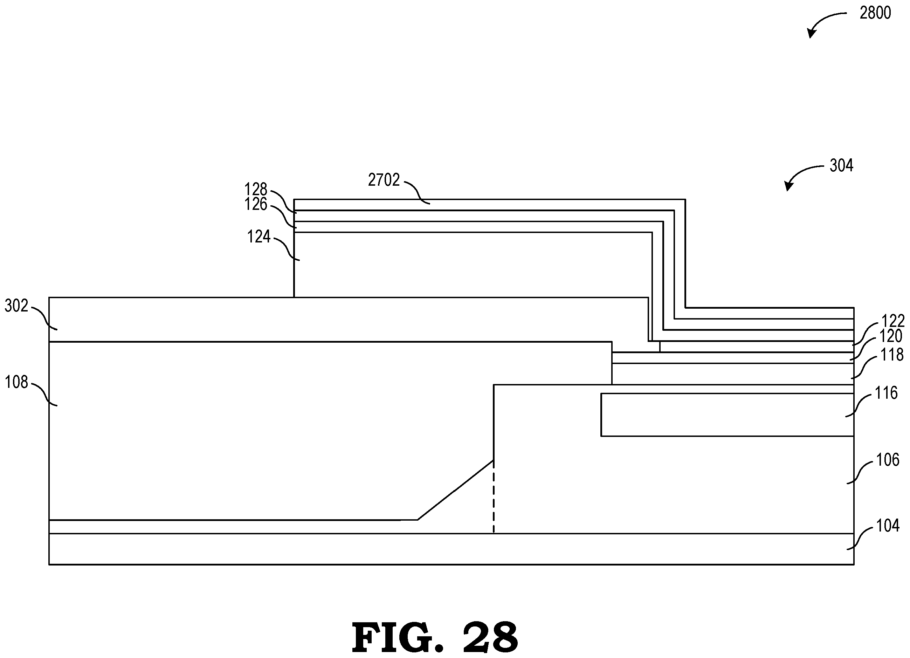

Referring next to block 2612 of FIG. 26 and to FIG. 28, during a stage of fabrication 2800, patterned etch processes (e.g., a sequence of patterned, selective RIE processes, including oxide-selective and nitride-selective RIE processes) are performed to remove portions of the second dielectric layer 2702, the second spacer layer 128, the first spacer layer 126, and the first dielectric layer 124. The removed portions of the second dielectric layer 2702, the second spacer layer 128, the first spacer layer 126, and the first dielectric layer 124 are disposed over the isolation region 108 and do not overlap the collector region 106. In one or more other embodiments, an additional patterned RIE process may be performed at this stage to remove a portion of the polycrystalline semiconductor layer 302.

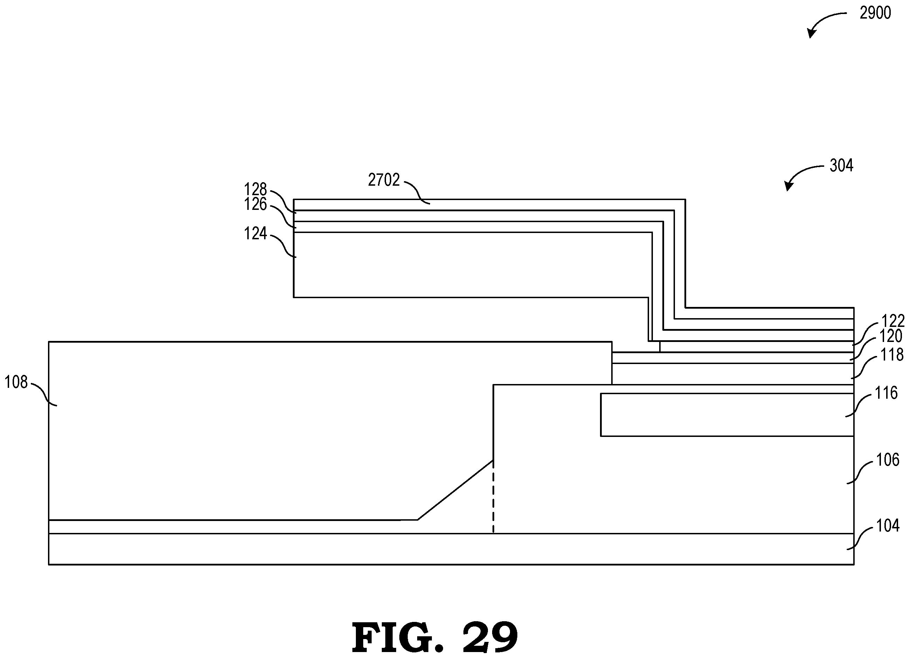

Referring next to block 2614 of FIG. 26 and to FIG. 29, during a stage of fabrication 2900, the polycrystalline semiconductor layer 302 is removed via an etch process. In one or more embodiments, a chemical etch process, using hydrogen chloride gas (HCl) as a non-limiting example, may be performed to remove the polycrystalline semiconductor layer 302. In one or more other embodiments, an RIE process may instead be performed to remove the polycrystalline semiconductor layer 302.

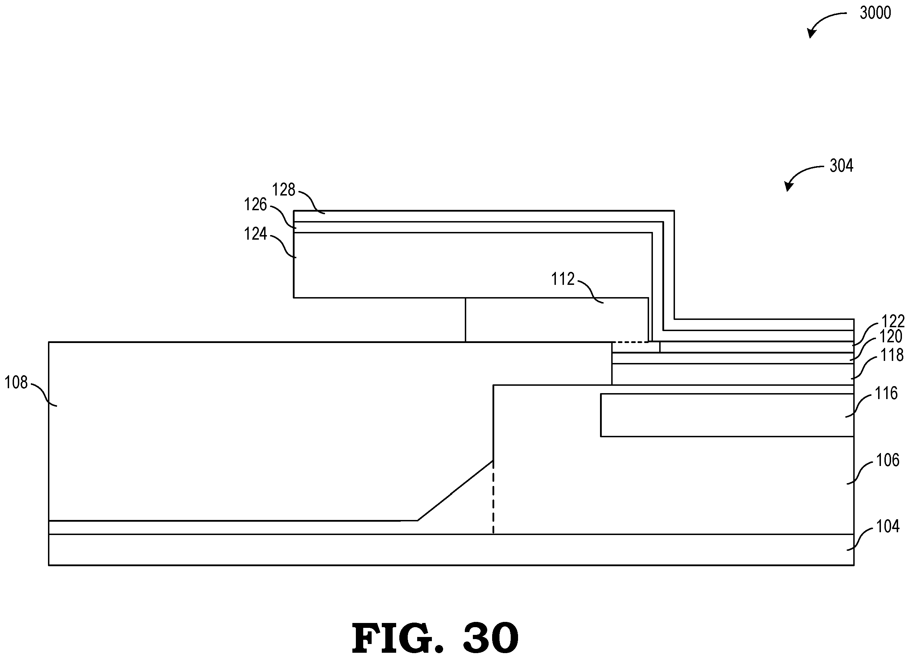

Referring next to block 2616 of FIG. 26 and to FIG. 30, during a stage of fabrication 3000, during a stage of fabrication 1700, a monocrystalline extrinsic base region 112 is formed via selective epitaxial growth (i.e., grown from portions of the monocrystalline intrinsic base region 120 that were exposed during removal of the polycrystalline semiconductor layer 302 at block 1314). In one or more embodiments, the monocrystalline extrinsic base region 112 may be epitaxially grown to fill only a portion of the space under the dielectric layer 124 (e.g., such that amorphous semiconductor material 2504 may be subsequently formed in the opening under the dielectric layer 124, eventually forming part of the extrinsic base of the transistor device 2501).

In one or more embodiments, exposed surfaces of the substrate may be cleaned (e.g., using hydrofluoric acid (HF)) prior to selective epitaxial growth of the extrinsic base region 112. In one or more embodiments, dopants may be added in-situ (during growth of extrinsic base region 112) or added by way of ion implantation. In one or more embodiments in which the transistor device 1201 is a pnp transistor, the extrinsic base region 112 may be doped with n-type dopants, such as P, As, Sb, Li, or another suitable n-type dopant. In one or more embodiments in which the transistor device 2501 is a npn transistor, the extrinsic base region 112 may be doped with p-type dopants, such as B, Al, In, or another suitable p-type dopant. The dopant concentration of the extrinsic base region 112 may be in a range of around 1e20 cm⁻³ to 5e21 cm⁻³, although higher or lower dopant concentrations may be used. The presence of the first and second spacer layers 126 and 128 in the emitter window 304 may protect the emitter cap layer 122 and intrinsic base region 120 during the HF pre-cleaning process and subsequent formation of the monocrystalline extrinsic base region 112 at this stage.

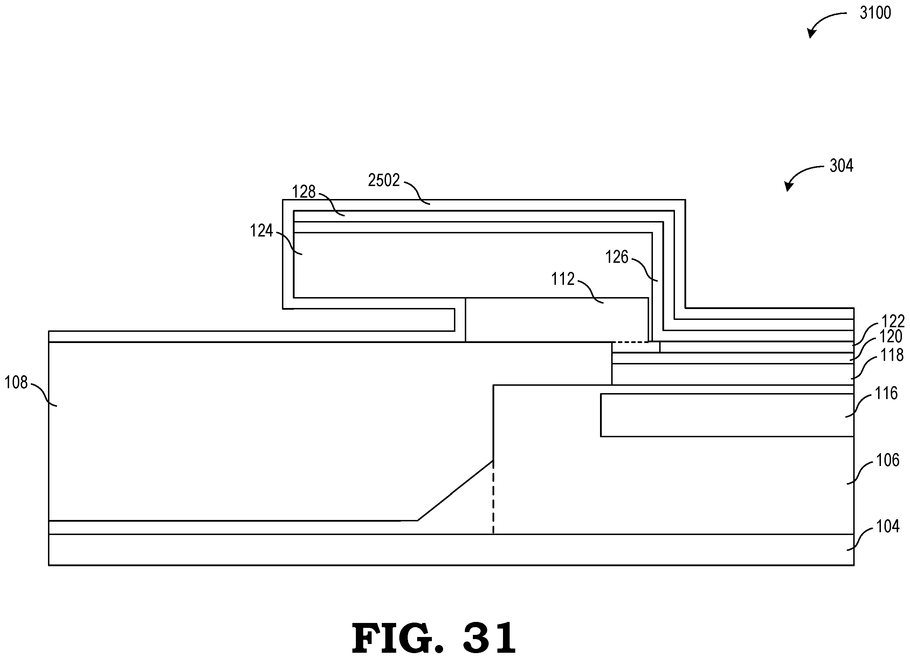

Referring next to block 2618 of FIG. 26 and to FIG. 31, during a stage of fabrication 3100, a third dielectric layer 2502 is deposited over the substrate 102, including on surfaces of the second spacer layer 128, the first dielectric layer 124, the monocrystalline extrinsic base region 112, and the isolation region 108. In one or more embodiments, the third dielectric layer 2502 includes oxide material (e.g., SiO₂, TEOS, or Al₂O₃ as non-limiting examples).

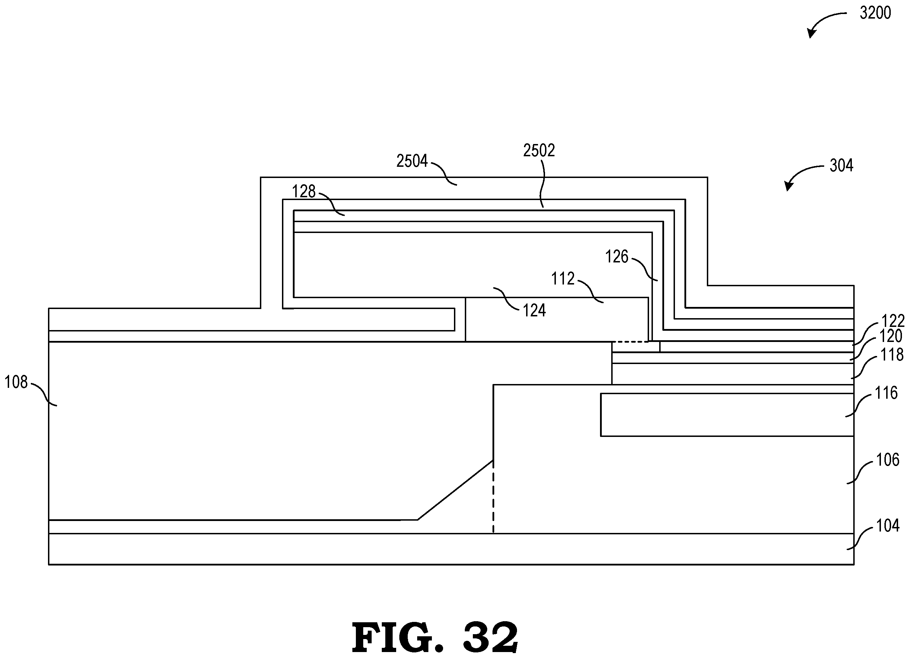

Referring next to block 2620 of FIG. 26 and to FIG. 32, during a stage of fabrication 3200, amorphous semiconductor material 2504 is formed over the substrate 102 via non-selective epitaxial growth. The amorphous semiconductor material 2504 may directly contact the third dielectric layer 2502. As shown, a portion of the amorphous semiconductor material 2504 is formed directly between the dielectric layer 124 and the isolation region 108 and adjacent to the extrinsic base region 112. In one or more embodiments, the amorphous semiconductor material 2504 includes silicon.

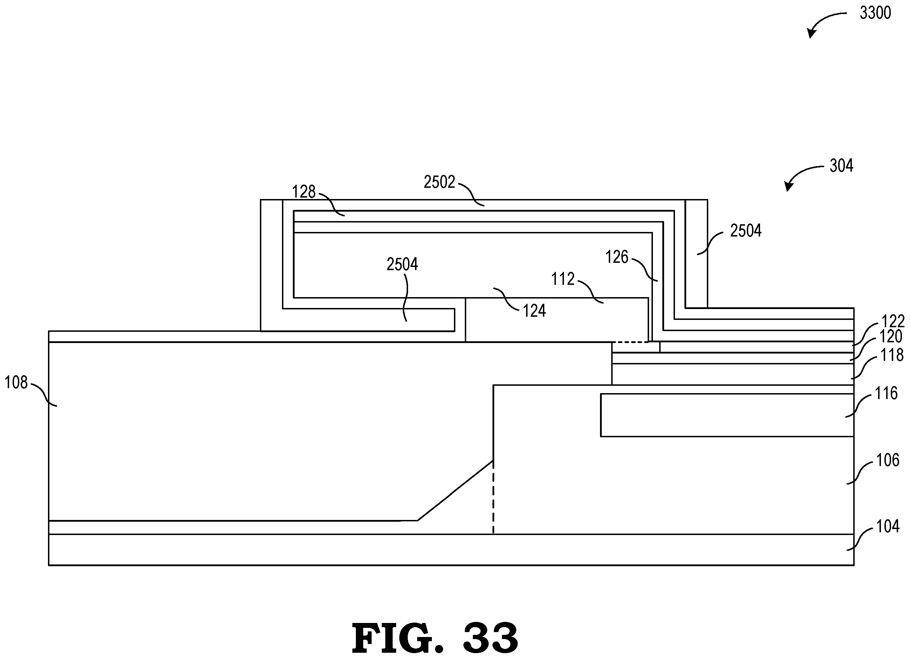

Referring next to block 2622 of FIG. 26 and to FIG. 33, during a stage of fabrication 3300, portions of the amorphous semiconductor material 2504 are removed via an unpatterned RIE etch process. Remaining portions of the amorphous semiconductor material 2504 may be disposed under and laterally adjacent to the dielectric layer 124 and, separately, in the emitter window 304.

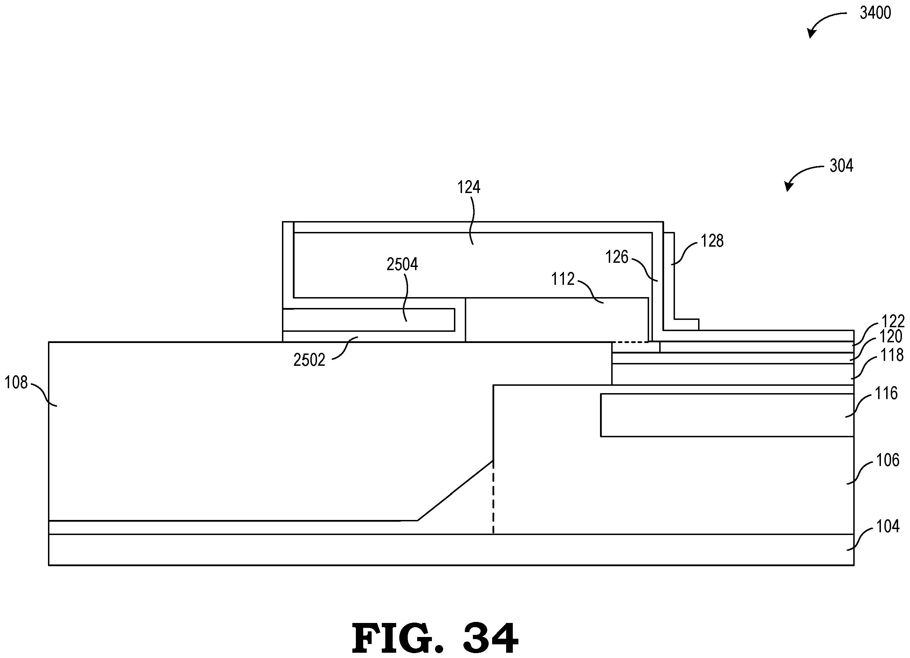

Referring next to block 2624 of FIG. 26 and to FIG. 34, during a stage of fabrication 3400, portions of the third dielectric layer 2502, portions of the second spacer layer 128, and portions of the amorphous semiconductor material 2504 are removed via one or more etch processes. For example, these etch processes may include an oxide-selective RIE etch followed by a nitride-selective RIE etch, in accordance with one or more embodiments. Removal of the portions of the second spacer layer 128 may form a first L-shaped portion of the spacer structure 129.

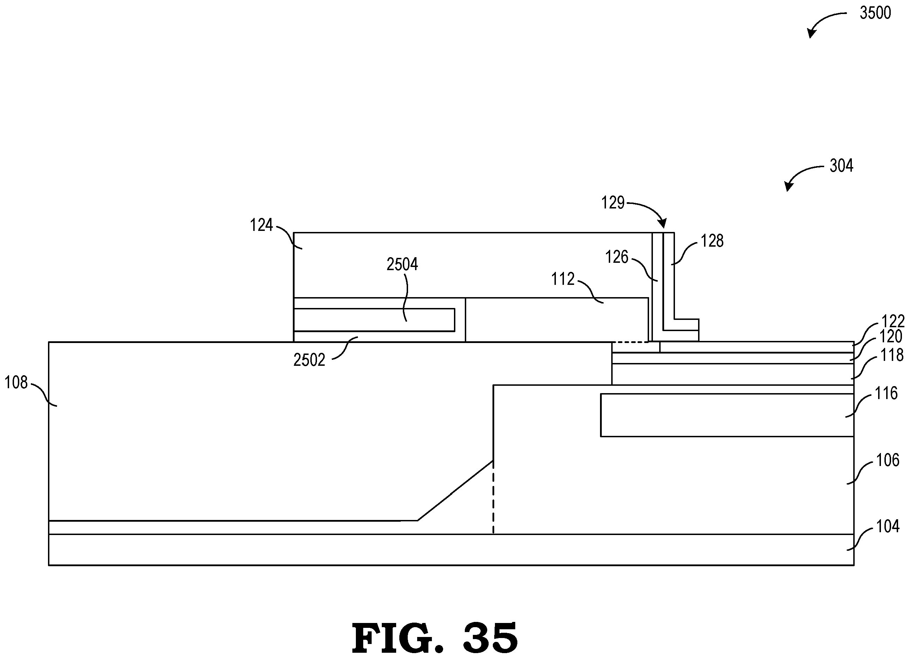

Referring next to block 2626 of FIG. 26 and to FIG. 35, during a stage of fabrication 3500, portions of the first spacer layer 126 and the third dielectric layer 2502 are removed via one or more etch processes. In one or more embodiments, these etch processes include an oxide-selective wet chemical etch. Removal of the portions of the first spacer layer 126 at this stage may form a second L-shaped portion of the spacer structure 129. Following the etch processes of blocks 2624 and 2626, portions of the third dielectric layer 2502 and the amorphous semiconductor material 2504 may remain under the first dielectric layer 124, where the remaining amorphous semiconductor material 2504 may act as part of the extrinsic base of the transistor device 2501

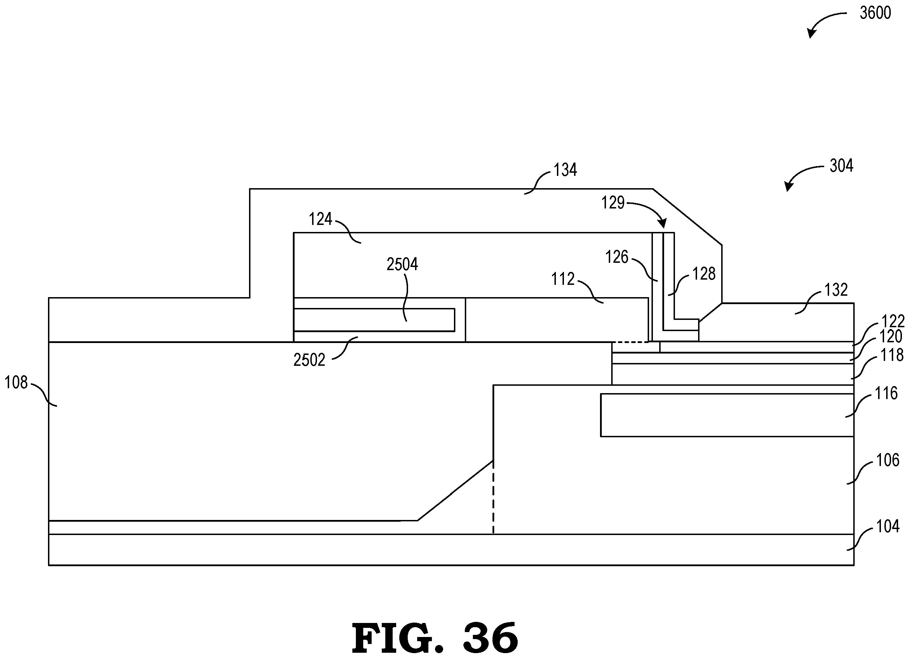

Referring next to block 2628 of FIG. 26 and to FIG. 36, during a stage of fabrication 3600, emitter regions 132 and 134 are formed over the substrate 102 via a non-selective epitaxial growth process. The emitter region 132 may be grown from the emitter cap layer 122 and may be formed from monocrystalline semiconductor material (e.g., monocrystalline Si, Ge, SiGe, GaAs, GaN, AlN, InN, InGaP, and/or other suitable semiconductor materials). The emitter region 134 may be grown on dielectric surfaces, such as those of the isolation region 108 and the dielectric layer 124 and may be formed from polycrystalline semiconductor material (e.g., polycrystalline Si, Ge, SiGe, GaAs, GaN, AlN, InN, InGaP, and/or other suitable semiconductor materials). In one or more other embodiments, the emitter region 134 may be formed as an amorphous semiconductor layer, which would become polycrystalline after any subsequent thermal annealing.

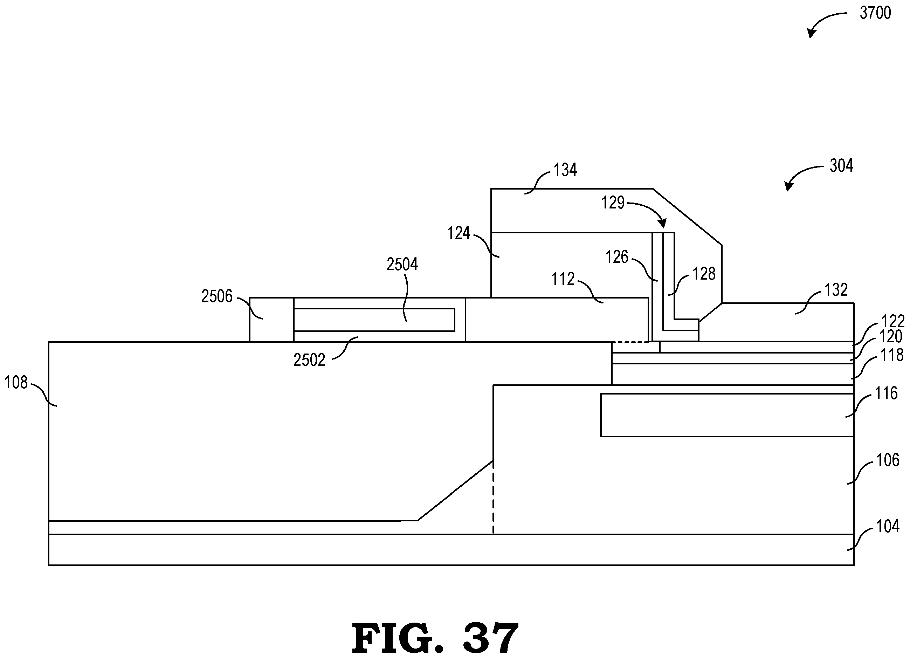

Referring next to block 2630 of FIG. 26 and to FIG. 37, during a stage of fabrication 3700, one or more patterned etch processes are performed to remove respective portions of emitter layer 134 and first the dielectric layer 124 in conjunction with one or more photolithographic processes. In one or more embodiments, a portion of the emitter layer 134 disposed over the extrinsic base layer 112 and the isolation region 108 may be removed via a selective RIE process, then a portion of the dielectric layer 124 disposed on the upper surface of the extrinsic base layer 112 and on an upper surface of the third dielectric layer 2502 may be removed via a nitride-selective RIE process. As shown, removal of the portion of the dielectric layer 124 at block 2630 may expose at least a portion of the upper surface of the extrinsic base layer 112 and the upper surface of the third dielectric layer 2502. In one or more embodiments, remnants of the emitter layer 134 that and that are not completely removed by the etch processes of block 2630 may remain as polycrystalline semiconductor material 2506, disposed laterally adjacent to third dielectric layer 2502 and the amorphous semiconductor material 2504.

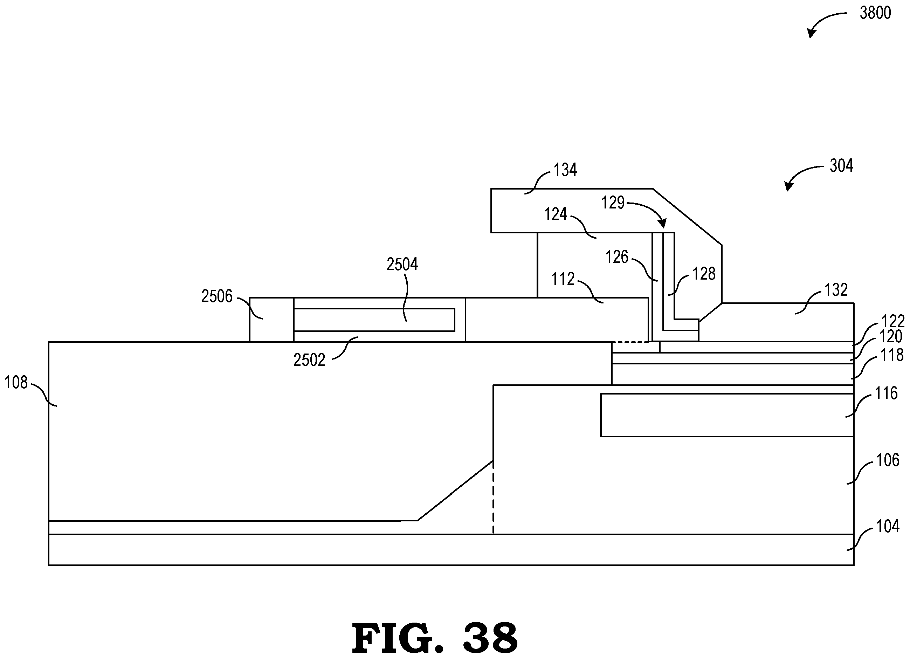

Referring next to block 2632 of FIG. 26 and to FIG. 38, during a stage of fabrication 3800, a portion of the dielectric layer 124 is removed via a wet chemical etch process (e.g., a nitride-selective wet chemical etch process). This etch process may undercut the emitter region 134, such that a portion of the emitter region 134 overhangs the dielectric layer 124.

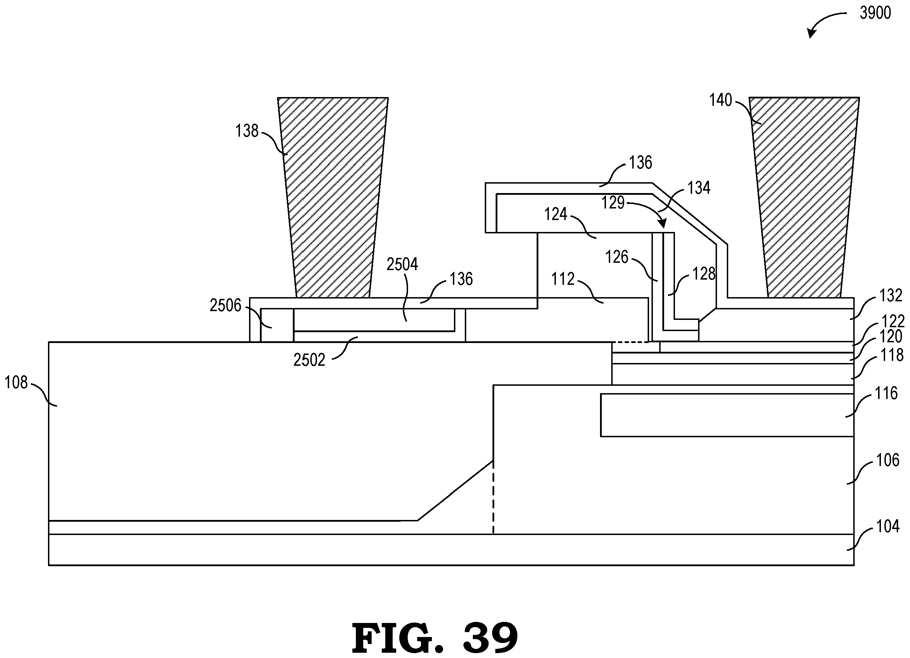

Referring next to block 2634 of FIG. 26 and to FIG. 39, during a stage of fabrication 3900, the contact layer 136, the base electrode 138, and the emitter electrode 140 are formed. The contact layer 136 may be formed directly on the extrinsic base region 112, on the emitter regions 132 and 134, the amorphous semiconductor material 2504, the polycrystalline semiconductor material 2506, and a portion of the third dielectric layer 2502 disposed directly between the amorphous semiconductor material 2504 and the extrinsic base region 112. The base electrode 138 may be formed over the amorphous semiconductor material 2504 directly on the contact layer 136. The emitter electrode 140 may be formed over the emitter region 132 directly on the contact layer 136. In one or more embodiments, the contact layer 136 is formed via a silicidation process. In one or more embodiments, the base electrode 138 and emitter electrode 140 are formed via one more metal deposition processes (e.g., sputtering, evaporation, plating, or another suitable metal deposition process) where the deposited metal is then patterned using suitable photolithography and etch processes. In one or more embodiments, the contact layer 136 includes one or more of TiW, TiWN, WSi, CoSi, PtSi, NiPtSi, or one or more other suitable material(s). In one or more embodiments, the base electrode 138 and the emitter electrode 140 may include one or more of copper, aluminum, tungsten, or another suitable conductive material. In one or more embodiments, the wafer on which the transistor device 101 is being formed may be annealed (e.g., heated to between 900 °C and 1100 °C) at block 2634.

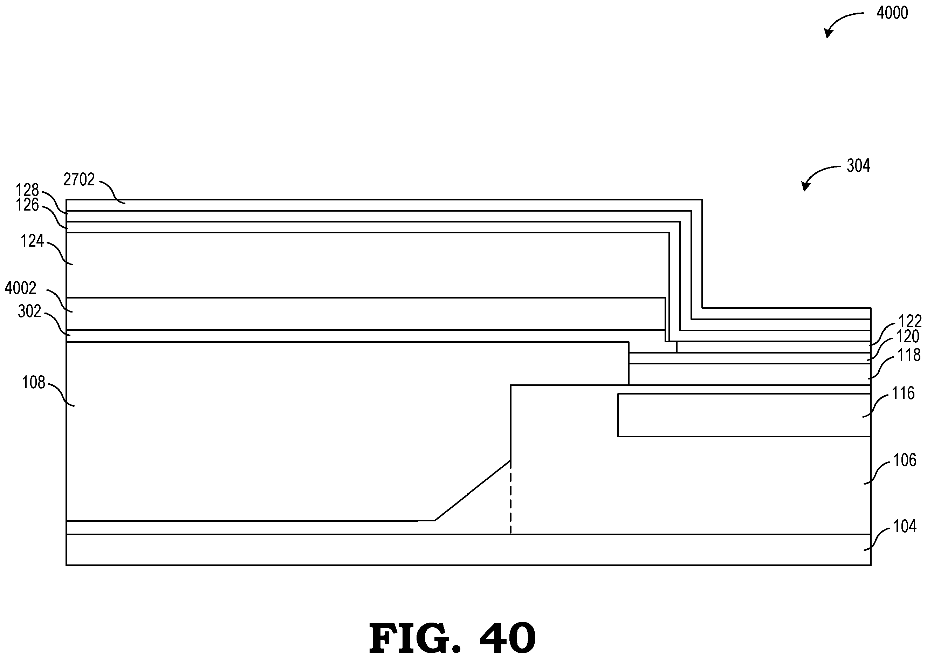

In one or more embodiments, during fabrication of the transistor device 2501, the area under the first dielectric layer 124 may be occupied by a layer of dielectric material in addition to the polycrystalline semiconductor material 302. To illustrate, stages of fabrication 4000, 4100, 4200, and 4300 of FIGS. 40-43 may be used in place of the stages of fabrication 2700, 2800, 2900, and 3000 in one or more such embodiments. In the following example, the polycrystalline semiconductor layer 302 may, advantageously, be etched more rapidly, as the formation of the dielectric layer 4002 allows a thinner polycrystalline semiconductor layer 302 to be used. This allows for faster removal of the polycrystalline semiconductor layer 302 and/or improved control of the etch process used to remove the polycrystalline semiconductor layer 302.

As shown in FIG. 40, at the stage of fabrication 4000, a second dielectric layer 2702, a first spacer layer126, and a second spacer layer 128 are formed (e.g., deposited) over the substrate 102. As shown, a dielectric layer 4002 is disposed between the polycrystalline semiconductor layer 302 and the first dielectric layer 124. The dielectric layer 4002 may be formed on the polycrystalline semiconductor layer 302 at a previous stage of fabrication (e.g., occurring between block 2604 and 2606 of the method 2600 of FIG. 26). In one or more embodiments, the dielectric layer 4002 may be formed from material different from that of the first dielectric layer 124. For example, the dielectric layer 4002 may be formed from oxide material (e.g., SiO₂, TEOS, or Al₂O₃, as non-limiting examples), and the first dielectric layer 124 may be formed from nitride material (e.g., SiN, SiON, or AlN, as non-limiting examples).

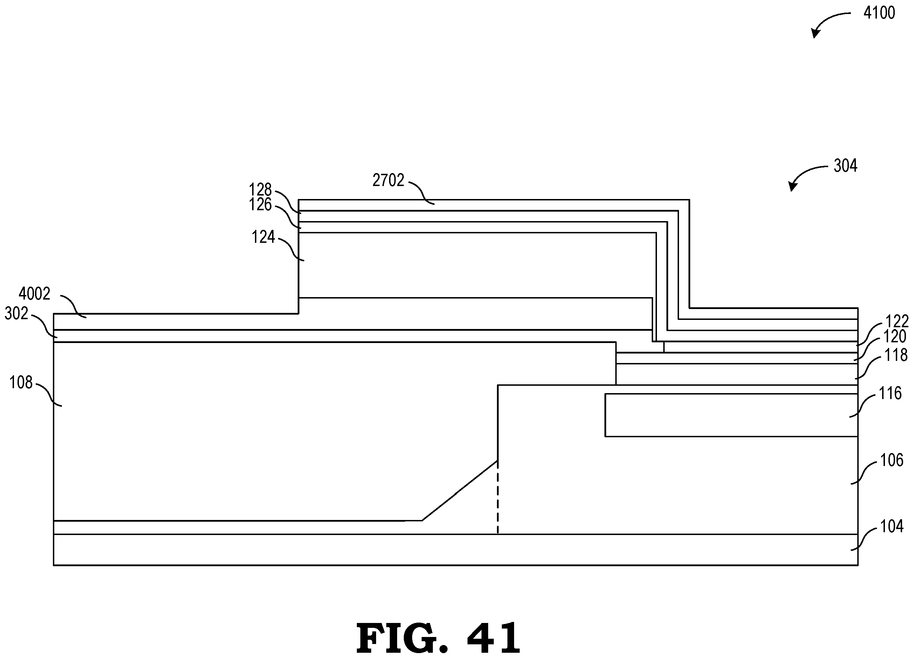

As shown in FIG. 41, at the stage of fabrication 4100, patterned etch processes (e.g., a sequence of patterned, selective RIE processes, including oxide-selective and nitride-selective RIE processes) are performed to remove portions of the second dielectric layer 2702, the second spacer layer 128, the first spacer layer 126, the first dielectric layer 124, and at least a portion of the dielectric layer 4002. In one or more embodiments, as shown, the etch process used to remove the portion of the dielectric layer 4002 may only etch through a portion of the thickness of the dielectric layer 4002. In one or more other embodiments, the etch process used to remove the portion of the dielectric layer 4002 may etch through the entire thickness of the dielectric layer 4002. In one or more other embodiments, when etching completely through the portion of the dielectric layer 4002, an additional patterned etch process (e.g., RIE process) may be performed to remove a portion of the polycrystalline semiconductor layer 302.

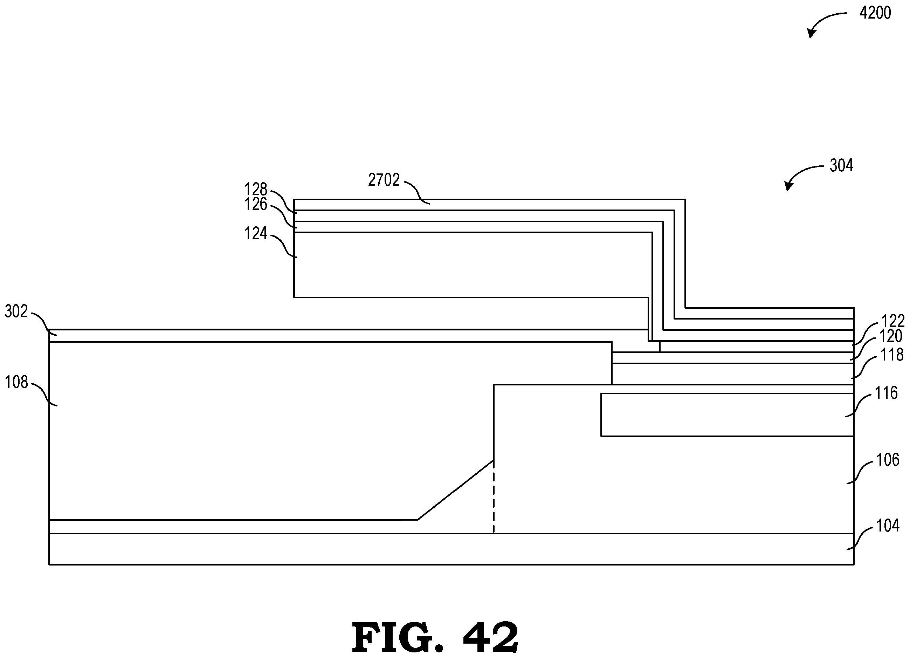

As shown in FIG. 42, at the stage of fabrication 4200, a wet chemical etch (e.g., BOE, HF, or another suitable wet chemical etch) may be performed to remove remaining portions of the dielectric layer 4002 and the second dielectric layer 2702.

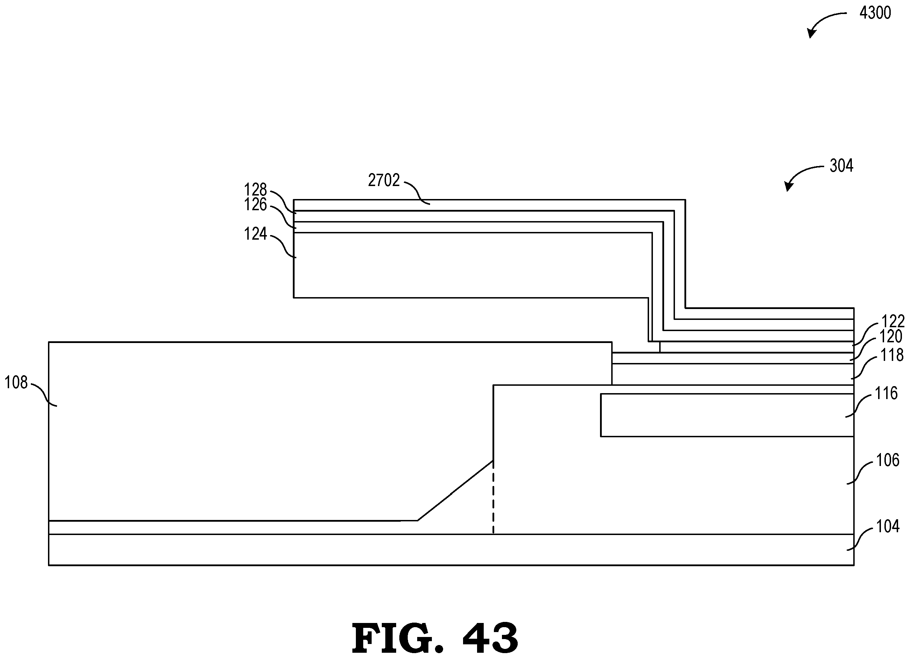

As shown in FIG. 43, at the stage of fabrication 4300, a chemical etch process, using hydrogen chloride gas (HCl) as a non-limiting example, may be performed to remove the polycrystalline semiconductor layer 302. After the stage of fabrication 4300, the stages of fabrication of FIGS. 30-39 in conjunction with blocks 2616-2632 of the method 200 of FIG. 2 may be performed to form the transistor device 2501. In one or more other embodiments, an RIE process may instead be performed to remove the polycrystalline semiconductor layer 302.

It should be understood that, in addition to those processing steps described herein, other processing steps may be performed to complete any of the transistor devices 101, 1201, and 2501 of FIGS. 1, 12, and 25, including, but not limited to, the deposition and patterning of additional dielectric layers and/or metal layers and/or the formation of molding or underfill material.

According to a first aspect of the present disclosure, there is provided a method includes providing a substrate that includes a dielectric isolation region and a collector region that includes semiconductor material, forming a polycrystalline semiconductor layer over the substrate, forming a monocrystalline intrinsic base layer via epitaxial growth, wherein the intrinsic base layer is in direct contact with the polycrystalline semiconductor layer, removing the polycrystalline semiconductor layer after forming the monocrystalline intrinsic base layer, and forming a monocrystalline extrinsic base layer via epitaxial growth, wherein the monocrystalline extrinsic base layer is in direct contact with the monocrystalline intrinsic base layer.

In one or more embodiments, the method further includes forming a dielectric spacer structure by forming a first spacer layer over the substrate, forming a second spacer layer over the substrate, etching portions of the second spacer layer, and etching portions of the first spacer layer. The dielectric spacer structure may be disposed over the monocrystalline intrinsic base layer.

In one or more embodiments, the method further includes forming a polycrystalline emitter layer and a monocrystalline emitter layer over the substrate via epitaxial growth, the polycrystalline emitter layer at least partially overlaps the monocrystalline extrinsic base layer, the monocrystalline emitter layer overlaps the monocrystalline intrinsic base layer, and the dielectric spacer structure is interposed between the monocrystalline extrinsic base layer and the monocrystalline emitter layer and is interposed between the polycrystalline emitter layer and the monocrystalline intrinsic base layer.

In one or more embodiments, removing the polycrystalline semiconductor layer and forming the monocrystalline extrinsic base layer are performed after etching the portions of the second spacer layer.

In one or more embodiments, removing the polycrystalline semiconductor layer and forming the monocrystalline extrinsic base layer are performed before forming the dielectric spacer structure.

In one or more embodiments, removing the polycrystalline semiconductor layer and forming the monocrystalline extrinsic base layer are performed after forming the first spacer layer and forming the second spacer layer and before etching the portions of the second spacer layer and etching the portions of the first spacer layer.

In one or more embodiments, the method further includes forming a first dielectric stack on the polycrystalline semiconductor layer, and forming an emitter window by etching a first opening in the first dielectric stack and the polycrystalline semiconductor layer. The first opening may expose an upper surface of the collector region, and the dielectric spacer structure may be formed in the emitter window.

In one or more embodiments, the method further includes forming a launcher layer on the exposed surface of the collector region via selective epitaxial growth, where forming the monocrystalline intrinsic base layer further includes forming the monocrystalline intrinsic base layer on the launcher layer via selective epitaxial growth, and forming an emitter cap layer on the intrinsic base layer. The emitter cap layer and the launcher layer may each comprise silicon.

In an example embodiment, a method of fabricating a transistor device includes forming, via non-selective epitaxial growth, a polycrystalline semiconductor layer over an isolation region and a collector region of substrate, forming, via selective epitaxial growth, a monocrystalline intrinsic base layer over the collector region, removing the polycrystalline semiconductor layer via one or more etch processes, and forming, via selective epitaxial growth, a monocrystalline extrinsic base layer that directly contacts the monocrystalline intrinsic base layer.

In one or more embodiments, the method further includes forming a dielectric spacer structure by forming a first spacer layer over the substrate, forming a second spacer layer over the substrate, etching portions of the second spacer layer, and etching portions of the first spacer layer. The dielectric spacer structure may be disposed over the monocrystalline intrinsic base layer.

In one or more embodiments, the method further includes forming a polycrystalline emitter layer and a monocrystalline emitter layer over the substrate via epitaxial growth, the polycrystalline emitter layer at least partially overlaps the monocrystalline extrinsic base layer, the monocrystalline emitter layer overlaps the monocrystalline intrinsic base layer, and the dielectric spacer structure is interposed between the monocrystalline extrinsic base layer and the monocrystalline emitter layer and is interposed between the polycrystalline emitter layer and the monocrystalline intrinsic base layer.

In one or more embodiments, removing the polycrystalline semiconductor layer and forming the monocrystalline extrinsic base layer are performed after etching the portions of the second spacer layer.

In one or more embodiments, removing the polycrystalline semiconductor layer and forming the monocrystalline extrinsic base layer are performed before forming the dielectric spacer structure.

In one or more embodiments, removing the polycrystalline semiconductor layer and forming the monocrystalline extrinsic base layer are performed after forming the first spacer layer and forming the second spacer layer and before etching the portions of the second spacer layer and etching the portions of the first spacer layer.

In one or more embodiments, the method further includes forming a first dielectric stack on the polycrystalline semiconductor layer, and forming an emitter window by etching a first opening in the first dielectric stack and the polycrystalline semiconductor layer. The first opening may expose an upper surface of the collector region and the dielectric spacer structure may be formed in the emitter window.

In one or more embodiments, the method further includes forming a launcher layer on the exposed surface of the collector region via selective epitaxial growth, where forming the monocrystalline intrinsic base layer further includes forming the monocrystalline intrinsic base layer on the launcher layer via selective epitaxial growth, and forming an emitter cap layer on the intrinsic base layer, where the emitter cap layer and the launcher layer each comprise silicon.

According to a second aspect of the present disclosure, there is provided a heterojunction bipolar transistor (HBT) device includes a substrate that includes a collector region and an isolation region, a base region that includes a monocrystalline intrinsic base layer disposed over the collector region and a monocrystalline extrinsic base layer disposed over the isolation region, where the monocrystalline extrinsic base layer is in direct contact with the monocrystalline intrinsic base layer, an emitter region that includes a polycrystalline emitter layer disposed over the monocrystalline extrinsic base layer, and a monocrystalline emitter layer disposed over the monocrystalline intrinsic base layer, where the polycrystalline emitter layer is in direct contact with the monocrystalline emitter layer; and a dielectric spacer structure disposed between the base region and the emitter region.

In one or more embodiments, the HBT device further includes a dielectric layer disposed directly between the monocrystalline extrinsic base layer and the polycrystalline emitter layer and in direct contact with the dielectric spacer structure, a launcher layer disposed directly between the monocrystalline intrinsic base layer and the collector region, and an emitter cap layer disposed directly between the monocrystalline intrinsic base layer and the monocrystalline emitter layer.

In one or more embodiments, the base region further includes amorphous silicon material disposed directly between the dielectric layer and the isolation region and disposed laterally adjacent to the monocrystalline extrinsic base layer.

In one or more embodiments, the HBT device further includes a contact layer formed from silicide that electrically connects the amorphous silicon material to the monocrystalline extrinsic base layer, and the amorphous silicon material is separated from the monocrystalline extrinsic base layer by dielectric material.

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with) another element, and not necessarily mechanically. Thus, although the schematic shown in the figures depict one exemplary arrangement of elements, additional intervening elements, devices, features, or components may be present in one or more embodiments of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with guidance for implementing the described embodiment or embodiments. It should be understood that various changes can be made in the function and arrangement of elements without departing from the scope defined by the claims.

## Claims

1. A method comprising:
providing a substrate that includes a dielectric isolation region and a collector region that includes semiconductor material;
forming a polycrystalline semiconductor layer over the substrate;
forming a monocrystalline intrinsic base layer via epitaxial growth, wherein the intrinsic base layer is in direct contact with the polycrystalline semiconductor layer;
removing the polycrystalline semiconductor layer after forming the monocrystalline intrinsic base layer; and
forming a monocrystalline extrinsic base layer via epitaxial growth, wherein the monocrystalline extrinsic base layer is in direct contact with the monocrystalline intrinsic base layer.

2. The method of claim 1, further comprising:
forming a dielectric spacer structure by:
forming a first spacer layer over the substrate;
forming a second spacer layer over the substrate;
etching portions of the second spacer layer; and
etching portions of the first spacer layer, wherein the dielectric spacer structure is disposed over the monocrystalline intrinsic base layer.

3. The method of claim 2, further comprising:
forming a polycrystalline emitter layer and a monocrystalline emitter layer over the substrate via epitaxial growth, wherein the polycrystalline emitter layer at least partially overlaps the monocrystalline extrinsic base layer, the monocrystalline emitter layer overlaps the monocrystalline intrinsic base layer, and the dielectric spacer structure is interposed between the monocrystalline extrinsic base layer and the monocrystalline emitter layer and is interposed between the polycrystalline emitter layer and the monocrystalline intrinsic base layer.

4. The method of claim 2 or 3, wherein removing the polycrystalline semiconductor layer and forming the monocrystalline extrinsic base layer are performed after etching the portions of the second spacer layer.

5. The method of any of claims 2 to 4, wherein removing the polycrystalline semiconductor layer and forming the monocrystalline extrinsic base layer are performed before forming the dielectric spacer structure.

6. The method of claim 2, wherein removing the polycrystalline semiconductor layer and forming the monocrystalline extrinsic base layer are performed after forming the first spacer layer and forming the second spacer layer and before etching the portions of the second spacer layer and etching the portions of the first spacer layer.

7. The method of claim 2, further comprising:
forming a first dielectric stack on the polycrystalline semiconductor layer; and
forming an emitter window by etching a first opening in the first dielectric stack and the polycrystalline semiconductor layer, wherein the first opening exposes an upper surface of the collector region, wherein the dielectric spacer structure is formed in the emitter window.

8. The method of claim 7, further comprising:
forming a launcher layer on the exposed surface of the collector region via selective epitaxial growth, wherein forming the monocrystalline intrinsic base layer further includes forming the monocrystalline intrinsic base layer on the launcher layer via selective epitaxial growth; and
forming an emitter cap layer on the intrinsic base layer, wherein the emitter cap layer and the launcher layer each comprise silicon.

9. The method of any preceding claim, wherein the collector region forms the collector of a transistor, the transistor having a base comprising the monocrystalline extrinsic base layer and the monocrystalline intrinsic base layer.

10. The method of claim 9, further comprising:
forming a dielectric spacer structure by:
forming a first spacer layer over the substrate;
forming a second spacer layer over the substrate;
etching portions of the second spacer layer; and
etching portions of the first spacer layer, wherein the dielectric spacer structure is disposed over the monocrystalline intrinsic base layer.

11. The method of claim 9, further comprising:
forming a polycrystalline emitter layer and a monocrystalline emitter layer over the substrate via epitaxial growth, wherein the polycrystalline emitter layer at least partially overlaps the monocrystalline extrinsic base layer, the monocrystalline emitter layer overlaps the monocrystalline intrinsic base layer, and the dielectric spacer structure is interposed between the monocrystalline extrinsic base layer and the monocrystalline emitter layer and is interposed between the polycrystalline emitter layer and the monocrystalline intrinsic base layer.

12. A heterojunction bipolar transistor, HBT, device comprising:
a substrate comprising a collector region and an isolation region;
a base region comprising:
a monocrystalline intrinsic base layer disposed over the collector region; and
a monocrystalline extrinsic base layer disposed over the isolation region, wherein the monocrystalline extrinsic base layer is in direct contact with the monocrystalline intrinsic base layer;
an emitter region comprising:
a polycrystalline emitter layer disposed over the monocrystalline extrinsic base layer; and
a monocrystalline emitter layer disposed over the monocrystalline intrinsic base layer, wherein the polycrystalline emitter layer is in direct contact with the monocrystalline emitter layer; and
a dielectric spacer structure disposed between the base region and the emitter region.

13. The HBT device of claim 12, further comprising:
a dielectric layer disposed directly between the monocrystalline extrinsic base layer and the polycrystalline emitter layer and in direct contact with the dielectric spacer structure;
a launcher layer disposed directly between the monocrystalline intrinsic base layer and the collector region; and
an emitter cap layer disposed directly between the monocrystalline intrinsic base layer and the monocrystalline emitter layer.

14. The HBT device of claim 13, wherein the base region further comprises amorphous silicon material disposed directly between the dielectric layer and the isolation region and disposed laterally adjacent to the monocrystalline extrinsic base layer.

15. The HBT device of claim 14, further comprising:
a contact layer formed from silicide that electrically connects the amorphous silicon material to the monocrystalline extrinsic base layer, wherein the amorphous silicon material is separated from the monocrystalline extrinsic base layer by dielectric material.
